# EUROPEAN PATENT APPLICATION

(11) **EP 1 814 170 A2**
(43) Date of publication of application: **01.08.2007**
(21) Application number: 06255108.0
(22) Date of filing: 03.10.2006
(51) Int. Cl.: H01L 41/083, H01L 41/047

(54) **Piezoelectric/electrostrictive actuator**

(30) Priority: 27.01.2006 JP 2006018865; 22.09.2006 JP 2006258089
(71) Applicant: NGK INSULATORS, LTD., Nagoya-city, Aichi 467-8530 (JP)
(72) Inventor: Yoshioka, Kunihiko, Legal Affairs and IP Dept., Nagoya City, Aichi-ken 467-8530 (JP); Ohmori, Makoto, Legal Affairs and IP Dept., Nagoya City, Aichi-ken 467-8530 (JP); Kimura, Koji, Legal Affairs and IP Dept., Nagoya City, Aichi-ken 467-8530 (JP)
(74) Representative: Naylor, Matthew John

(57) **Abstract**

A piezoelectric/electrostrictive actuator includes a piezoelectric body, a plurality of internal electrode layers, side-surface electrodes, and a plurality of electrode lead portions. The internal electrode layers formed only at a central portion of the piezoelectric body. Thus, an active portion is formed at the central portion of the piezoelectric body, and an inactive portion in which no voltage is applied to the piezoelectric body and the piezoelectric body neither expands nor contracts is formed to surround the central portion. The internal electrode layers are formed such that the width of the inactive portion is at least a single layer thickness of the piezoelectric body, which is the distance between a pair of internal electrode layers facing each other, and in a cross section in which each internal electrode layer is formed, the inactive portion has an area not greater than 50% the area of the entire cross section.

## Description

### BACKGROUND OF THE INVENTION

### Field of the Invention:

The present invention relates to a piezoelectric/electrostrictive actuator utilizing expansion and contraction of a plurality of piezoelectric body layers that are substantially stacked on one another.

### Description of the Related Art:

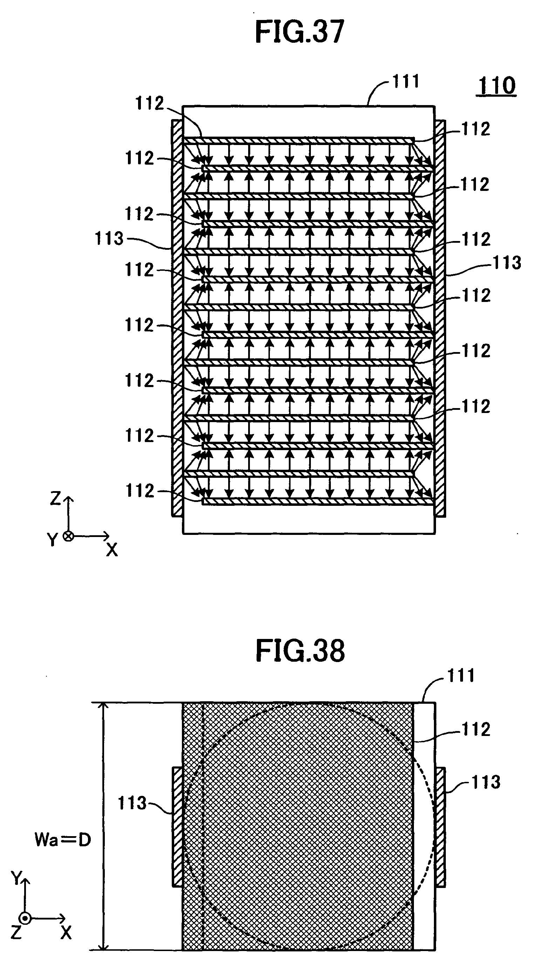

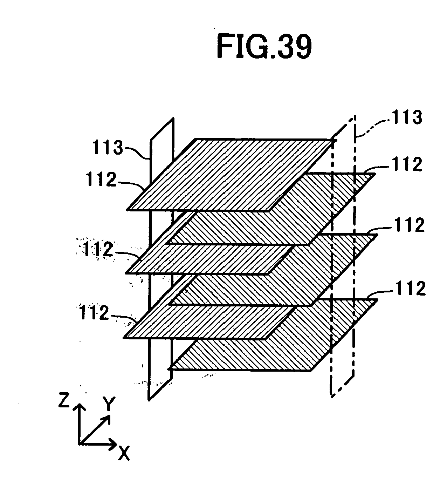

As shown in FIGS. 37 to 39, a conventionally known piezoelectric/electrostrictive actuator 110 includes a generally rectangular parallelepipedic or cylindrical columnar piezoelectric body 111; a plurality of internal electrode layers 112 formed within the piezoelectric body 111 to be parallel with each other; and a pair of side-surface electrodes 113 formed on side surfaces of the piezoelectric body 111. Each of the internal electrode layers 112 is formed to be separated from one side-side surface electrode 113, extends to and along the outer circumference of the piezoelectric body 111, and is connected to the other side-surface electrode 113.

With this structure, voltages of opposite polarities are alternately applied to the internal electrode layers 112 via the side-surface electrodes 113. Thus, as indicated by arrows in FIG. 37, electric fields are applied to the piezoelectric body 111, so that the piezoelectric body 111 expands and contracts. The piezoelectric/electrostrictive actuator 110 utilizes such expansion and contraction so as to produce force. Such a piezoelectric/electrostrictive actuator is applied to, for example, a fuel injection valve (see Japanese Patent Application Laid-Open (kokai) No. 2004-297042).

However, in the conventional piezoelectric/electrostrictive actuator 110, since the internal electrode layers 112 do not have a symmetric shape, as shown in FIG. 37, electric fields of directions other than the axial direction of the piezoelectric body 111 (Z-axis direction) are applied to the piezoelectric body 111 in the vicinity of end portions of the internal electrode layers 112. Therefore, the direction of expansion and contraction of the piezoelectric body 111 in the vicinity of end portions thereof differs from that at the central portion thereof, so that a large stress is generated at the end portions of the piezoelectric body 111. As a result, the service life of the piezoelectric/electrostrictive actuator 110 may be shortened.

### SUMMARY OF THE INVENTION

The present invention has been accomplished so as to solve the above-described problem, and one of objects of the present invention is to provide a piezoelectric/electrostrictive actuator which can reduce the maximum stress generated inside a piezoelectric body and which has a long service life.

The present invention provides a piezoelectric/electrostrictive actuator comprising a piezoelectric body and a plurality of internal electrode layers formed in parallel within the piezoelectric body, in which a predetermined voltage is applied to the internal electrode layers so as to expand and contract the piezoelectric body. The internal electrode layers are disposed at a central portion of the piezoelectric body such that an active portion and an inactive portion are formed in the piezoelectric body, the active portion being the central portion of the piezoelectric body to which a voltage is applied so as to expand and contract the piezoelectric body, and the inactive portion being a peripheral portion of the piezoelectric body which surrounds the central portion of the piezoelectric body and in which no voltage is applied to the piezoelectric body and the piezoelectric body neither expands nor contracts. The internal electrode layers are formed such that the width of the inactive portion, which is the distance between the outer edge of the piezoelectric body and the active portion, is at least a single layer thickness of the piezoelectric body, which is the distance between a pair of internal electrode layers facing each other, and, in a cross section in which each internal electrode layer is formed, the inactive portion has an area equal to or less than 50% the area of the entire cross section.

By virtue of the above-described configuration, an inactive portion is formed over the entirety of a peripheral portion of the piezoelectric body which surrounds the central portion of the piezoelectric body serving as an active portion. Thus, because the boundary between the active portion and the inactive portion is not exposed to the outer edge (side surface) of the piezoelectric body where stress concentration is likely to occur due to surface roughness, surface flaws, or the like, the maximum stress generated in the piezoelectric body is reduced. As a result, the service life of the piezoelectric/electrostrictive actuator can be lengthened.

Since the width of the inactive portion is at least (or is not less than) the distance between a pair of internal electrode layers facing each other (that is, the thickness of a single layer of the piezoelectric body sandwiched between the pair of internal electrode layers facing each other), stress which is generated at the boundary between the active portion and the inactive portion due to deformation of the active portion acts generally equally in the active portion and the inactive portion and becomes small. In other words, since the active portion and the inactive portion equally absorb distortion stemming from deformation of the active portion, the stress generated within the inactive portion at the boundary between the active portion and the inactive portion becomes the smallest. This can also be explained from the so-called "Saint Venant's principle."

In addition, each of the internal electrode layers of the piezoelectric/electrostrictive actuator of the present invention is formed such that the area of the inactive portion in a cross section in which the internal electrode layer is formed (plane perpendicularly intersecting the axis of the piezoelectric body) becomes equal to or less than 50% the area of the entire cross section (the sum of the area of the active portion and the area of the inactive portion). As the width of the inactive portion increases, the stress (tensile stress) generated at the inactive portion decreases, as described. However, since the inactive portion functions to hinder deformation of the active portion, the amount of deformation decreases if the occupancy ratio of the inactive portion is large. Accordingly, in the case where the occupancy ratio of the inactive portion is large, the size of the piezoelectric body must be increased so as to obtain a desired deformation amount. In view of the above, the present inventors performed experiments and found that when the area of the inactive portion is equal to or less than 50% the sum of the area of the active portion and the area of the inactive portion, the piezoelectric/electrostrictive actuator can produce a sufficient amount of deformation. Accordingly, by virtue of the structure of the present invention, a compact piezoelectric/electrostrictive actuator which produces a large amount of deformation (or a large force based on the deformation) can be provided.

The present invention also provides a piezoelectric/electrostrictive actuator comprising a piezoelectric body and a plurality of internal electrode layers formed in parallel within the piezoelectric body, wherein a predetermined voltage is applied to the internal electrode layers so as to expand and contract the piezoelectric body. The internal electrode layers are disposed at a central portion of the piezoelectric body such that an active portion and an inactive portion are formed in the piezoelectric body, the active portion being the central portion of the piezoelectric body to which a voltage is applied so as to expand and contract the piezoelectric body, and the inactive portion being a peripheral portion of the piezoelectric body which surrounds the central portion of the piezoelectric body and in which no voltage is applied to the piezoelectric body and the piezoelectric body neither expands nor contracts. The piezoelectric/electrostrictive actuator further comprises:
electrode lead portions each generally assuming the form of a strip and extending from the internal electrode layers to side surfaces (side end portions) of the piezoelectric body, the width of the strip being equal to or less than 30% the diameter of a circle which can be drawn to have the largest area in an internal electrode layer without extending outside the outer edge of the internal electrode layer; and
side-surface electrodes formed on the side surfaces of the piezoelectric body so as to connect together end portions (or all of the end portions) of the corresponding electrode lead portions that are exposed to the side end portions of the piezoelectric body.

A voltage must be applied to the internal electrode layers in order to form the active portion. Supplying such voltage from the side-surface electrodes formed on the side surfaces of the piezoelectric body is advantageous from the viewpoint of simplifying the structure of the piezoelectric/electrostrictive actuator. However, if the width of the strip-shaped electrode lead portions, which connect the side-surface electrodes and the internal electrode layers, is excessively large, an electric field which is sufficiently strong to deform the piezoelectric body is generated from (or by) the electrode lead portions as well, with possible generation of large stress. In other words, the electrode lead portions might form an active portion in the peripheral portion of the piezoelectric body.

The present inventors found that when the width of the electrode lead portions (which extend from the internal electrode layers to the side end portions of the piezoelectric body and each of which generally assumes a strip like shape) is equal to or less than 30% the diameter of a circle which can be drawn to have the largest area in an internal electrode layer disposed at the center of the piezoelectric body without extending outside the outer edge of the internal electrode layer (the circle corresponds to an inscribed circle when the internal electrode layer has the shape of, for example, a regular polygon), a portion where the electrode lead portions are formed substantially functions as an inactive portion. Accordingly, by virtue of the above-described structure, even in the case where an active portion (i.e., internal electrode layers) is formed only in a central portion of the piezoelectric body and electrode lead portions are formed in a peripheral portion of the piezoelectric body surrounding the central portion, an inactive portion can be formed in the peripheral portion without fail. As a result, generation of excessive stress can be avoided, and thus, a piezoelectric/electrostrictive actuator having a long service life can be provided.

In this case, preferably, the shape (shape as viewed from above, or shape in a plane perpendicularly intersecting the thickness direction) of each internal electrode layer is a shape having n-fold symmetry, where n is an integer not less than 2, a rectangular shape, or an elliptical shape, or an oval shape. Since the shape of the internal electrodes has a high degree of symmetry, there can be provided a piezoelectric/electrostrictive actuator in which excessive stress is not generated.

### BRIEF DESCRIPTION OF THE DRAWINGS

Various other objects, features and many of the attendant advantages of the present invention will be readily appreciated as the same becomes better understood by reference to the following detailed description of the preferred embodiments when considered in connection with the accompanying drawings, in which:
FIG. 1 is a schematic perspective view of a piezoelectric/electrostrictive actuator according to a first embodiment of the present invention;
FIG. 2 is a schematic perspective view of one layer (portion sandwiched between a pair of opposed internal electrode layers) of the piezoelectric body of the piezoelectric/electrostrictive actuator shown in FIG. 1;
FIG. 3 is a vertical cross-sectional view of the piezoelectric/electrostrictive actuator shown in FIG. 1;
FIG. 4 is a cross sectional view of the piezoelectric/electrostrictive actuator shown in FIG. 1, taken along a plane extending along an internal electrode layer;
FIG. 5 is a conceptual diagram showing the connection between the internal electrode layers and side-surface electrodes of the piezoelectric/electrostrictive actuator shown in FIG. 1;
FIGS. 6A and 6B are conceptual diagrams showing internal stresses generated in an activate portion and an inactive portion of the piezoelectric body;
FIG. 7 is a graph showing the relation between active portion occupancy ratio and expansion/contraction amount of the piezoelectric body for the piezoelectric/electrostrictive actuator according to the embodiment and a conventional piezoelectric/electrostrictive actuator;
FIG. 8 is a graph showing changes in expansion/contraction amount of the piezoelectric body with the number of drive cycles of the piezoelectric/electrostrictive actuator;
FIG. 9 is a graph showing the relation between the active portion occupancy ratio of the piezoelectric body and the maximum stress generated in the piezoelectric body for the piezoelectric/electrostrictive actuator according to the embodiment and the conventional piezoelectric/electrostrictive actuator;
FIG. 10 is a cross sectional view of one modification of the piezoelectric/electrostrictive actuator shown in FIG. 1, taken along a plane extending along an internal electrode layer;
FIG. 11 is a cross sectional view of another modification of the piezoelectric/electrostrictive actuator shown in FIG. 1, taken along a plane extending along an internal electrode layer;
FIG. 12A is a cross sectional view of still another modification of the piezoelectric/electrostrictive actuator shown in FIG. 1, taken along a plane extending along an internal electrode layer;
FIG. 12B is a graph showing changes in expansion/contraction amount of the piezoelectric body with the number of drive cycles of the piezoelectric/electrostrictive actuator shown in FIG. 12A;
FIG. 13A is a cross sectional view of still another modification of the piezoelectric/electrostrictive actuator shown in FIG. 1, taken along a plane extending along an internal electrode layer;
FIG. 13B is a graph showing changes in expansion/contraction amount of the piezoelectric body with the number of drive cycles of the piezoelectric/electrostrictive actuator shown in FIG. 13A;
FIG. 14A is a cross sectional view of still another modification of the piezoelectric/electrostrictive actuator shown in FIG. 1, taken along a plane extending along an internal electrode layer;
FIG. 14B is a graph showing changes in expansion/contraction amount of the piezoelectric body with the number of drive cycles of the piezoelectric/electrostrictive actuator shown in FIG. 14A;
FIG. 15A is a cross sectional view of still another modification of the piezoelectric/electrostrictive actuator shown in FIG. 1, taken along a plane extending along an internal electrode layer;
FIG. 15B is a graph showing changes in expansion/contraction amount of the piezoelectric body with the number of drive cycles of the piezoelectric/electrostrictive actuator shown in FIG. 15A;
FIG. 16A is a cross sectional view of still another modification of the piezoelectric/electrostrictive actuator shown in FIG. 1, taken along a plane extending along an internal electrode layer;
FIG. 16B is a graph showing changes in expansion/contraction amount of the piezoelectric body with the number of drive cycles of the piezoelectric/electrostrictive actuator shown in FIG. 16A;
FIG. 17A is a cross sectional view of still another modification of the piezoelectric/electrostrictive actuator shown in FIG. 1, taken along a plane extending along an internal electrode layer;
FIG. 17B is a graph showing changes in expansion/contraction amount of the piezoelectric body with the number of drive cycles of the piezoelectric/electrostrictive actuator shown in FIG. 17A;
FIG. 18A is a cross sectional view of still another modification of the piezoelectric/electrostrictive actuator shown in FIG. 1, taken along a plane extending along an internal electrode layer;
FIG. 18B is a graph showing changes in expansion/contraction amount of the piezoelectric body with the number of drive cycles of the piezoelectric/electrostrictive actuator shown in FIG. 18A;
FIGS. 19A, 19B, and 19C are cross sectional views of still other modifications of the piezoelectric/electrostrictive actuator shown in FIG. 1, each taken along a plane extending along an internal electrode layer;
FIGS. 20A, 20B, 20C, and 20D are cross sectional views of still other modifications of the piezoelectric/electrostrictive actuator shown in FIG. 1, each taken along a plane extending along an internal electrode layer;
FIGS. 21A, 21B, and 21C are cross sectional views of still other modifications of the piezoelectric/electrostrictive actuator shown in FIG. 1, each taken along a plane extending along an internal electrode layer;
FIG. 22 is a vertical cross-sectional view of a piezoelectric/electrostrictive actuator according to a second embodiment of the present invention;
FIG. 23 is a cross sectional view of the piezoelectric/electrostrictive actuator shown in FIG. 22, taken along line 23-23 of FIG. 22;
FIG. 24 is a cross sectional view of the piezoelectric/electrostrictive actuator shown in FIG. 22, taken along line 24-24 of FIG. 22;
FIG. 25A is a cross sectional view of still another modification of the piezoelectric/electrostrictive actuator, taken along a plane extending along an internal electrode layer;
FIG. 25B is a vertical cross-sectional view of the piezoelectric/electrostrictive actuator shown in FIG. 25A;
FIG. 26A is a cross sectional view of still another modification of the piezoelectric/electrostrictive actuator, taken along a plane extending along an internal electrode layer;
FIG. 26B is a vertical cross-sectional view of the piezoelectric/electrostrictive actuator shown in FIG. 26A;
FIG. 27 is a figure for describing an individual-punching and laminating method;
FIG. 28 is an enlarged cross-sectional view of a sheet having a through hole formed by the individual-punching and laminating method;
FIG. 29 is an enlarged sectional view of a hollow cylindrical section formed by the individual-punching and laminating method;
FIG. 30 is a figure showing one process for forming a through hole by a simultaneous punching-laminating method;
FIG. 31 is a figure showing another process for forming through holes by the simultaneous punching-laminating method;
FIG. 32 is a figure showing still another process for forming through holes by the simultaneous punching-laminating method;
FIG. 33 is a figure showing still another process for forming through holes by the simultaneous punching-laminating method;
FIG. 34 is a figure showing still another process for forming through holes by the simultaneous punching-laminating method;
FIG. 35 is a partial enlarged cross-sectional view of the piezoelectric/electrostrictive actuator shown in FIGS. 26A and 26B;
FIG. 36A is a schematic perspective view of a piezoelectric/electrostrictive actuator easily manufactured by the simultaneous punching-laminating method;
FIG. 36B is a schematic perspective view of another piezoelectric/electrostrictive actuator easily manufactured by the simultaneous punching-laminating method;
FIG. 36C is a schematic perspective view of still another piezoelectric/electrostrictive actuator easily manufactured by the simultaneous punching-laminating method;
FIG. 37 is a vertical cross-sectional view of a conventional piezoelectric/electrostrictive actuator;
FIG. 38 is a cross sectional view of the piezoelectric/electrostrictive actuator shown in FIG. 37, taken along a plane extending along an internal electrode layer; and
FIG. 39 is a conceptual diagram showing the connection between the internal electrode layers and side-surface electrodes of the piezoelectric/electrostrictive actuator shown in FIG. 37.

### DESCRIPTION OF THE PREFERRED EMBODIMENTS

Embodiments of the piezoelectric/electrostrictive actuator according to the present invention will next be described in detail with reference to the drawings.

### First Embodiment:

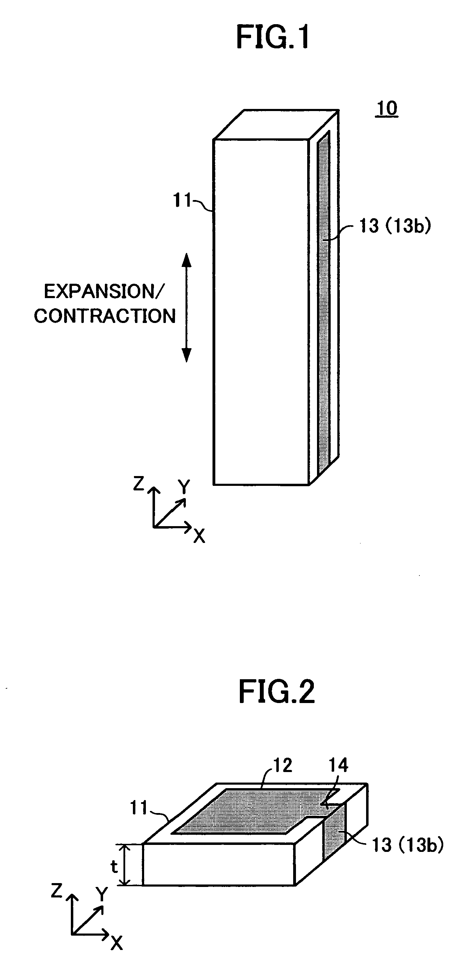

As shown in FIGS. 1 to 5, a piezoelectric/electrostrictive actuator 10 according to a first embodiment of the present invention includes a piezoelectric body 11, a plurality of internal electrode layers (internal electrodes) 12 (12a, 12b), a pair of side-surface electrodes 13 (13a, 13b), and a plurality of electrode lead portions 14 (14a, 14b).

The piezoelectric body (piezoelectric ceramic; PZT) 11 is a generally rectangular parallelepiped having sides along X, Y, and Z axes perpendicularly intersecting one another. The piezoelectric body 11 has a square cross section taken along a plane (X-Y plane) perpendicularly intersecting the Z-axis (longitudinal axis, lamination direction) of the piezoelectric body 11. When an electric field along the Z-axis is applied to the piezoelectric body 11, the piezoelectric body 11 expands along the direction of the electric field (along a direction parallel to the Z-axis).

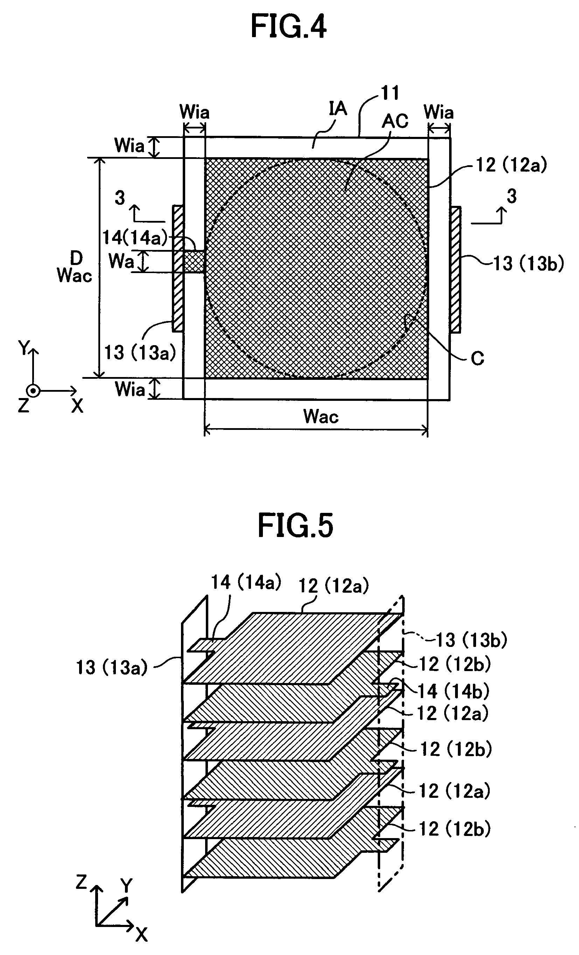

Each of the internal electrode layers 12 (12a, 12b) is a thin film formed of an electrically conductive material (e.g., Ag-Pd alloy) and having a thickness of, for example, 2 to 3 µm. The plurality of internal electrode layers 12 are embedded (formed) in the piezoelectric body 11 (along respective X-Y planes) such that they become parallel to one another. The internal electrode layers 12a and the internal electrode layers 12b are alternately disposed (along the Z-axis direction). Each of the internal electrode layers 12 (12a, 12b) assumes a square shape in a plane (along an X-Y plane) orthogonal to the Z axis, and its centroid coincides with the centroid of the piezoelectric body 11 within that plane (X-Y plane). The width of the active portion AC is Wac as shown in FIG. 4. Further, each side of each internal electrode layer 12 is parallel to the corresponding side of the piezoelectric body 11 in the above-described plane (X-Y plane). That is, the internal electrode layers 12 are disposed at a central portion of the piezoelectric body 11, and peripheral portions of the internal electrode layers 12 are surrounded by the piezoelectric body 11.

The pair of side-surface electrodes 13 are formed, in the form of a layer (thin film), on a pair of opposite side surfaces of the piezoelectric body 11. That is, one side-surface electrode 13a is formed on a Y-Z plane of the piezoelectric body 11 located on the X-axis negative-direction side with respect to the center axis of the piezoelectric body 11 (hereinafter, this Y-Z plane will be referred to as the "X-axis-negative-side Y-Z plane"); and the other side-surface electrode 13b is formed on a Y-Z plane of the piezoelectric body 11 located on the X-axis positive-direction side with respect to the center axis of the piezoelectric body 11 (hereinafter, this Y-Z plane will be referred to as the "X-axis-positive-side Y-Z plane"). The widths of the side-surface electrodes 13a and 13b are about half the length of the sides of the piezoelectric body 11, which sides extend along the Y-axis direction. Each of the side-surface electrodes 13a and 13b extends along the centerline of the corresponding side surface of the piezoelectric body 11 from the vicinity of the lower end to the vicinity of the upper end of the piezoelectric body 11.

Each of the electrode lead portions 14 is a thin film formed of an electrically conductive material (e.g., Ag-Pd alloy) identical with that of the internal electrode layers 12, and formed on the same plane as the corresponding internal electrode layer 12. The electrode lead portions 14 each assume the form of a strip extending along the X-axis direction and having a width Wa (length along the Y-axis direction). The electrode lead portions 14 each have a thickness identical with that of the internal electrode layers 12. One end of each electrode lead portion 14 is connected to one side of the corresponding internal electrode layer 12, and the other end thereof is exposed to one of the side surfaces of the piezoelectric body 11 on which the side-surface electrodes 13 are formed.

More specifically, in a region including the centerline of the X-axis-negative-side Y-Z plane of the piezoelectric body 11, a first group of electrode lead portions 14a among the electrode lead portions 14 connect (couple) the internal electrode layers 12a and the side-surface electrode 13a. Meanwhile, in a region including the centerline of the X-axis-positive-side Y-Z plane of the piezoelectric body 11, a second group of electrode lead portions 14b among the electrode lead portions 14 connect (couple) the internal electrode layers 12b and the side-surface electrode 13b. As will be described later, the width (length along the Y-axis direction) Wa is set to be equal to or less than 30% the diameter D of an inscribed circle C of the internal electrode layers 12. In the present specification, the inscribed circle of the internal electrode layers 12 is defined as a "circle which can be drawn within an internal electrode layer 12 without extending outside the outer edge (contour line) thereof and which has the maximum area (or the largest area) among all such circles."

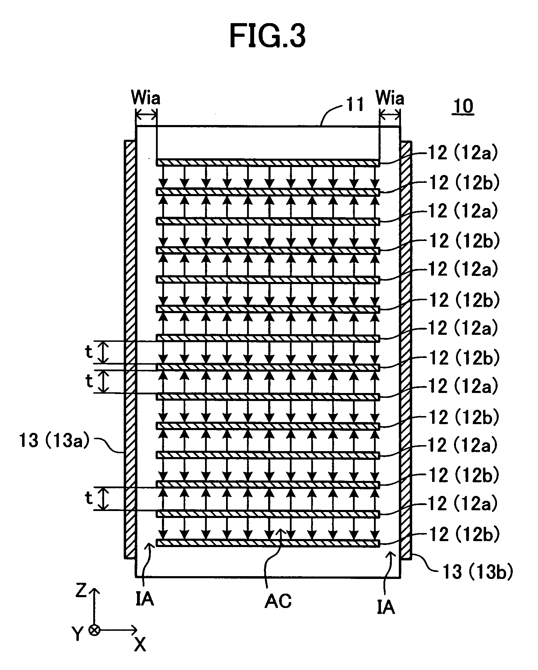

The piezoelectric/electrostrictive actuator 10 having the above-described configuration is subjected to a polarization process making use of the internal electrode layers (internal electrodes) 12. When the piezoelectric/electrostrictive actuator 10 is to be driven, predetermined voltages for expanding or contracting the piezoelectric body 11 is applied between the side-surface electrode 13a and the side-surface electrode 13b. For example, + V (V) is applied to the side-surface electrode 13a, and a reference voltage (e.g., 0 (V)) is applied to the side-surface electrode 13b. Thus, + V (V) is applied to one internal electrode layer 12a in each pair of the opposed internal electrode layers 12, and the reference voltage (e.g., 0 (V)) is applied to the other internal electrode layer 12b in the pair. As a result, a central portion of the piezoelectric body 11 (a portion sandwiched between the internal electrode layers 12a and 12b in each pair) is applied with an electric field directed in a direction shown by arrows in FIG. 3, which is a vertical cross-sectional view of the piezoelectric/electrostrictive actuator 10. Since this electric field is directed in the same direction as the polarization direction of the corresponding layer of the piezoelectric body 11, the piezoelectric body 11 expands along the Z-axis direction. After that, when the side-surface electrode 13a and the side-surface electrode 13b are maintained at the same potential (e.g., the reference voltage (0 (V)), the piezoelectric body 11 contracts, and is restored to the initial (original) condition. By making use of such expansion and contraction, the piezoelectric/electrostrictive actuator 10 moves, for example, a valve element of a fuel injection valve.

Alternatively, when the piezoelectric/electrostrictive actuator 10 having undergone the above-described polarization process is driven, voltages of different polarities (having the same magnitude each other) may be alternately applied to the plurality of internal electrode layers 12. For example, when + V (V) and - V (V) are applied to the side-surface electrodes 13a and 13b, respectively, voltages of different polarities are applied to the opposed internal electrode layers 12a and 12b, respectively, in each pair, whereby an electric field directed in a direction shown by arrows in FIG. 3 is applied to the central portion of the piezoelectric body 11. Since this electric field is directed in the same direction as the polarization direction of the corresponding layer, the piezoelectric body 11 expands along the Z-axis direction. After that, when the side-surface electrode 13a and the side-surface electrode 13b are maintained at the same potential (e.g., the reference voltage (0 (V)), the piezoelectric body 11 contracts, and is restored to the initial condition. Notably, FIG. 3 is a cross sectional view of the piezoelectric/electrostrictive actuator taken along line 3-3 of FIG. 4.

As described above, an active portion AC and an inactive portion IA are formed in the piezoelectric body 11 by the internal electrode layers 12. In the active portion AC (portion sandwiched between each pair of internal electrode layers 12 facing each other), the piezoelectric body 11 expands and contracts upon application of voltage to the central portion of the piezoelectric body 11. The inactive portion IA is a peripheral portion of the piezoelectric body 11 which surrounds the central portion (i.e., the active portion) of the piezoelectric body 11, to which no voltage is applied, and which does not expand or contract.

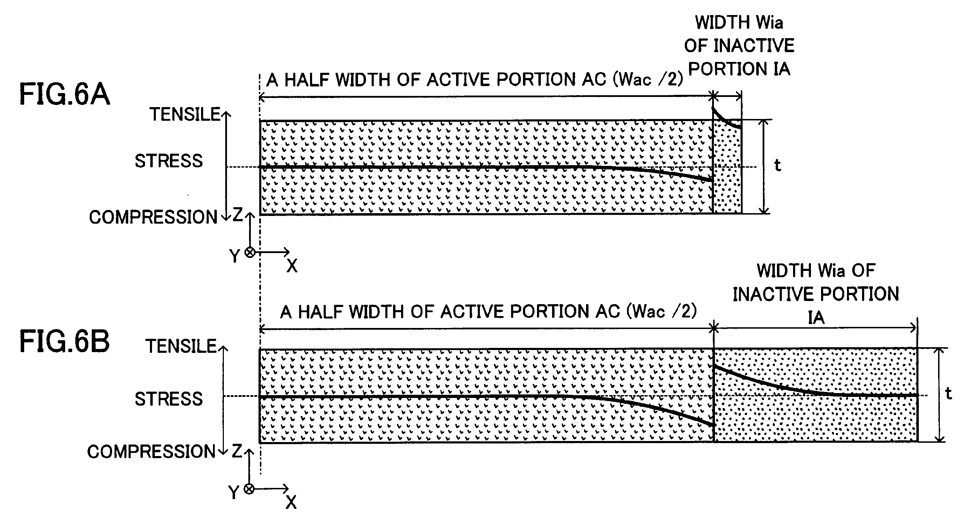

In the present embodiment, the width Wia of the inactive portion IA is constant over the entire circumference of the piezoelectric body 11, and is set to be equal to or greater than the thickness t of a single layer of the piezoelectric body, which is the distance between the opposed internal electrode layers 12a and 12b in each pair. The advantage attained through this dimensional setting will now be described with reference to FIGS. 6A and 6B.

Upon application of a voltage (electric field), the active portion AC deforms to expand in the thickness direction of the piezoelectric body layer. The inactive portion IA functions to try to suppress the expansion of the active portion AC. Accordingly, in the vicinity of the boundary between the active portion AC and the inactive portion IA (hereinafter referred to as a "near boundary region"), a compression stress is generated in the active portion AC, and a tensile stress is generated in the inactive portion IA. At this time, when the width Wia of the inactive portion IA is smaller than the thickness t of a single layer of the piezoelectric body as shown in FIG. 6A, the width Wia of the inactive portion IA is not sufficiently large to suppress the expansion of the active portion AC, so that a large tensile stress is generated in the inactive portion IA in the near boundary region. Meanwhile, the inactive portion IA hardly suppresses the expansion of the active portion AC, so that a small compression stress is generated in the active portion AC in the near boundary region.

In contrast, when the width Wia of the inactive portion IA is equal to or greater than the thickness t of a single layer of the piezoelectric body as in the present embodiment shown in FIG. 6B, the width Wia of the inactive portion IA is sufficiently large to try to suppress the expansion of the active portion AC, so that the tensile stress generated the inactive portion IA in the near boundary region is smaller than that in the case shown in FIG. 6A. Meanwhile, the inactive portion IA suppresses the expansion of the active portion AC in the near boundary region, so that the compression stress generated in the active portion AC in the near boundary region becomes larger than that in the case shown in FIG. 6A. At this time, the volume of the active portion AC relating to generation of the stress in the near boundary region is generally equal to the volume of the inactive portion IA relating to generation of the stress in the near boundary region. Therefore, distortion generated in the near boundary region is equally absorbed by the active portion AC and the inactive portion IA. Notably, such a phenomenon is known as "Saint Venant's principle."

As a result, in the piezoelectric/electrostrictive actuator 10 of the present embodiment, no excessive stress (tensile stress) is generated in the inactive portion IA in the vicinity of the boundary between the active portion AC and the inactive portion IA. Therefore, the actuator is excellent in durability and has a long service life. Notably, in the case where, unlike the present embodiment, the width Wia of the inactive portion changes (not constant in the circumferential direction), the minimum value of the width Wia of the inactive portion must be equal to or greater than the thickness t of a single layer of the piezoelectric body.

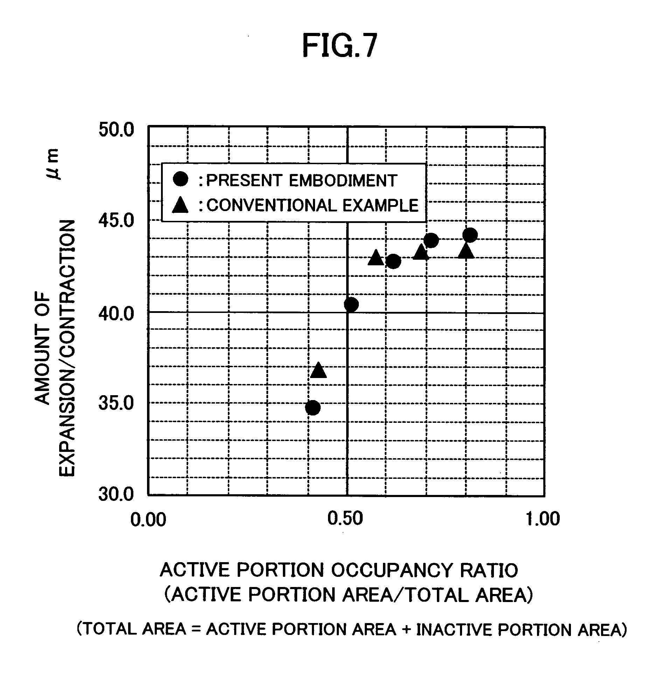

Further, in the present embodiment, the internal electrode layers 12 are formed in such a manner that, in a cross section (X-Y plane) in which each internal electrode layer 12 is formed, the area of the inactive portion IA is equal to or less than 50% the area of the entire cross section (the sum of the area of the active portion AC and the area of the inactive portion IA). The advantage attained through this setting will now be described with reference to FIG. 7.

FIG. 7 is a graph showing the relation between active portion occupancy ratio and the amount of expansion and contraction of the piezoelectric/electrostrictive actuator 10. The active portion occupancy ratio refers to the ratio of the area of the active portion AC to the sum of the area of the active portion AC and the area of the inactive portion IA in a plane on which the internal electrode layer 12 is formed. Notably, in FIG. 7, circular marks show the amounts of expansion and contraction of the piezoelectric/electrostrictive actuator 10 of the present embodiment, and triangular marks show the amounts of expansion and contraction of the conventional piezoelectric/electrostrictive actuator shown in FIGS. 37 to 39.

As is apparent from FIG. 7, when the active portion occupancy ratio becomes less than 50%, the amount of expansion and contraction of the piezoelectric/electrostrictive actuator 10 sharply decreases. In other words, since the piezoelectric/electrostrictive actuator 10 of the present embodiment has an active portion occupancy ratio of 50% or higher, the piezoeiectric/etectrostrictive actuator 10 can be used as an actuator having a reduced size and a large expansion and contraction amount.

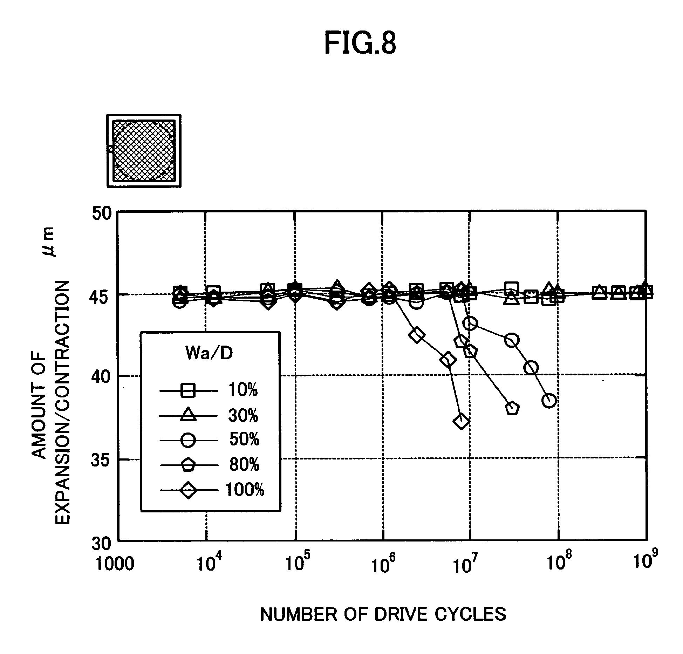

As described above, the width Wa of the electrode lead portions 14 of the piezoelectric/electrostrictive actuator 10 is set to 30% or less the diameter D of a circle which can be drawn within an internal electrode layer 12 without extending outside the outer edge thereof and which has the maximum area among all such circles (in the piezoelectric/electrostrictive actuator 10, the circle being an inscribed circle of the internal electrode layer 12). The advantage attained through this setting will now be described with reference to FIG. 8.

FIG. 8 is a graph showing changes in expansion/contraction amount of the piezoelectric body 11 with the number of drive cycles of the piezoelectric/electrostrictive actuator 10. Here, an operation of expanding the piezoelectric body 11 through application of a voltage to the internal electrode layers 12 and then contracting (restoring) the piezoelectric body 11 to the initial condition by stopping the application of the voltage to the internal electrode layers 12 corresponds to a single drive cycle. In FIG. 8, rectangular marks, triangular marks, circular marks, pentagonal marks, and rhombic marks represent the amounts of expansion and contraction for the cases where the ratio (Wa/D) of the width Wa of the electrode lead portions 14 to the diameter D of the inscribed circle is 10%, 30%, 50%, 80%, and 100%, respectively. Notably, the 100% ratio (Wa/D) corresponds to the case where the width of the electrode lead portions is equal to that of the piezoelectric body 111 as in the conventional piezoelectric/electrostrictive actuator 110 shown in FIG. 38.

As is apparent from FIG. 8, when the width Wa (Wa/D) of the electrode lead portions 14 in relation to the diameter D of the inscribed circle becomes equal to or higher than 50%, the amount of expansion and contraction decreases in a region where the number of drive cycles exceeds 10⁶. In contrast, when the width Wa of the electrode lead portions 14 in relation to the diameter D of the inscribed circle becomes equal to or less than 30%, the amount of expansion and contraction does not decrease even when the number of drive cycles reaches 10⁹. In view of this, in the piezoelectric/electrostrictive actuator 10 of the present embodiment, the ratio (Wa/D) of the width Wa of the electrode lead portions 14 to the diameter D of the inscribed circle is set to 30% or less. Accordingly, the piezoelectric/electrostrictive actuator 10 hardly decreases in the amount of expansion and contraction even when the number of drive cycles increases, and therefore has enhanced durability.

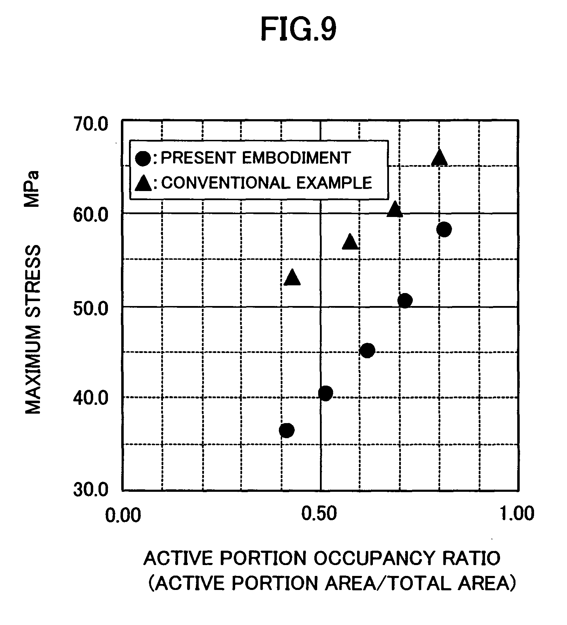

As described above, in the piezoelectric/electrostrictive actuator 10, since the width Wa of the electrode lead portions 14 is small, substantially no electric field (which is an electric field which expands and contracts the piezoelectric body 11) is generated from (or by) the electrode lead portions 14. Accordingly, the inactive portion IA can be formed in the piezoelectric body 11 to surround the active portion AC. This point will be described with reference to FIG. 9.

FIG. 9 is a graph showing the relation between the active portion occupancy ratio of the piezoelectric body and the maximum stress within the piezoelectric body. In FIG. 9, circular marks represent the maximum stress of the piezoelectric/electrostrictive actuator 10, and triangular marks represent the maximum stress of the piezoelectric/electrostrictive actuator 110 shown in FIGS. 37 to 39.

As is apparent from FIG. 9, in the piezoelectric/electrostrictive actuator 10 having an inactive portion extending over the entire peripheral portion of the piezoelectric body 11, the maximum stress becomes smaller as compared with the piezoelectric/electrostrictive actuator 110 in which an inactive portion does not extend over the entire peripheral portion of the piezoelectric body 111 due to the large width of the electrode lead portions. Conceivably, this reduction in the maximum stress occurs as a result of the following two major factors. That is, in the piezoelectric/electrostrictive actuator 10, (1) the active portion and the inactive portion are arranged with a high degree of symmetry, and therefore, distortion generated in the active portion is efficiently used in expansion and contraction in a desired expansion/contraction direction (in this case, Z-axis direction); and (2) the boundary between the active portion and the inactive portion is not exposed to the outer edge (side surface) of the piezoelectric body where stress concentration is likely to occur due to surface roughness, surface flaws, or the like.

### <Modifications of First Embodiment>

Next, modifications of the first embodiment will be described.

### (First modification)

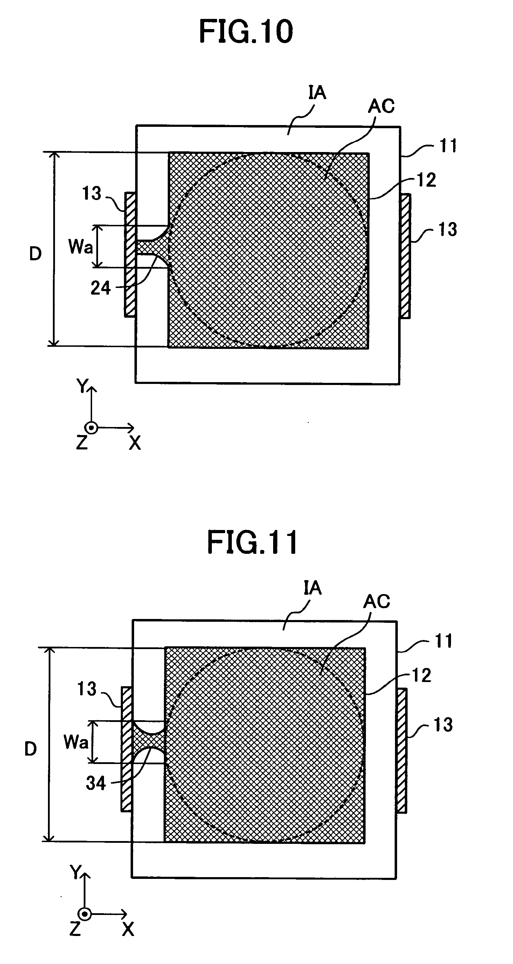

A first modification differs from the first embodiment only in the point that the first modification includes electrode lead portions 24 in place of the electrode lead portions 14 of the first embodiment (the piezoelectric/electrostrictive actuator 10), as shown in FIG. 10, which is a cross sectional view of the piezoelectric/electrostrictive actuator of the first modification, taken along a plane extending along an internal electrode layer.

Each electrode lead portion 24 assumes a shape such that its width is the minimum at a side surface of the piezoelectric body 11 where the corresponding side-surface electrode 13 is formed, and increases toward the corresponding internal electrode layer 12. This configuration suppresses stress concentration occurring at the connection portion between the internal electrode layer 12 and the electrode lead portion 24, so that cracks are hardly generated in the connection portion. Notably, the width Wa (width to be compared with the diameter D of the inscribed circle) of the electrode lead portion 24 having such a shape is the maximum width of the electrode lead portion 24.

### (Second modification)

A second modification differs from the first embodiment only in the point that the second modification includes electrode lead portions 34 in place of the electrode lead portions 14 of the first embodiment (the piezoelectric/electrostrictive actuator 10), as shown in FIG. 11, which is a cross sectional view of the piezoelectric/electrostrictive actuator of the second modification, taken along a plane extending along an internal electrode layer.

Each electrode lead portion 34 assumes a shape such that its width is the minimum at a generally central position between the corresponding internal electrode layer 12 and a side surface of the piezoelectric body 11 where the corresponding side-surface electrode 13 is formed, gradually increases toward the side surface where the corresponding side-surface electrode 13 is formed, and gradually increases toward the corresponding internal electrode layer 12. This configuration suppresses stress concentration occurring at the connection portion between the internal electrode layer 12 and the electrode lead portion 34, so that cracks are hardly generated in the connection portion. Further, the longer connection portion between the electrode lead portion 34 and the side-surface electrode 13 enables reliable connection therebetween (improves the reliability of connection). Notably, the width Wa (width to be compared with the diameter D of the inscribed circle) of the electrode lead portion 34 having such a shape is the maximum width of the electrode lead portion 34.

### (Third modification)

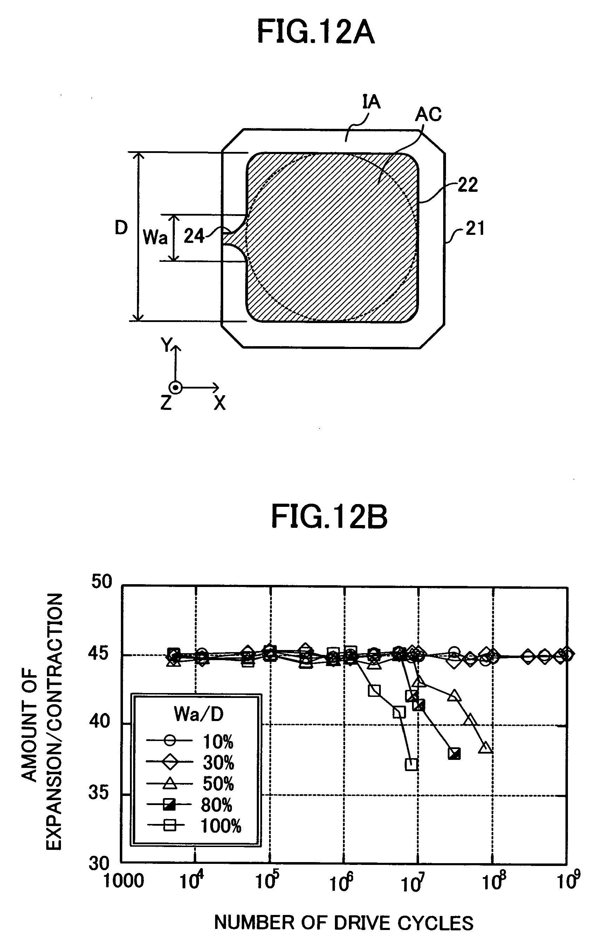

A third modification differs from the first embodiment only in the point that the third modification includes a piezoelectric body 21, internal electrode layers 22, and the electrode lead portions 24 in place of the piezoelectric body 11, the internal electrode layers 12, and the electrode lead portions 14 of the first embodiment (the piezoelectric/electrostrictive actuator 10), as shown in FIG. 12A, which is a cross sectional view of the piezoelectric/electrostrictive actuator of the third modification, taken along a plane extending along an internal electrode layer.

The piezoelectric body 21 assumes an octagonal outer shape (shape as viewed from above) obtained by chamfering corner portions of a square. Each internal electrode layer 22 has a shape of the internal electrode layer 12 with rounded corners (rounded corners are added to the layer 12). Each electrode lead portion 24 has the shape as described above. FIG. 12B is a graph showing changes in expansion/contraction amount of the piezoelectric body 21 with the number of drive cycles for the piezoelectric/electrostrictive actuator of the third modification. In FIG. 12B, circular marks, rhombic marks, triangular marks, half-black square marks, and square marks represent the amounts of expansion and contraction for the cases where the ratio (Wa/D) of the width Wa of the electrode lead portions 24 to the diameter D of the inscribed circle is 10%, 30%, 50%, 80%, and 100%, respectively.

As is apparent from FIG. 12B, when the width Wa (Wa/D) of the electrode lead portions 24 in relation to the diameter D of the inscribed circle becomes equal to or higher than 50%, the amount of expansion and contraction decreases in a region where the number of drive cycles exceeds 10⁶. In contrast, when the width Wa of the electrode lead portions 24 in relation to the diameter D of the inscribed circle becomes equal to or less than 30%, the amount of expansion and contraction does not decrease even when the number of drive cycles reaches 10⁹. This also shows that setting the width Wa of the electrode lead portions 24 in relation to the diameter D of the inscribed circle to 30% or less is desired, from the viewpoint of improving the durability of the piezoelectric/electrostrictive actuator 10.

### (Fourth modification)

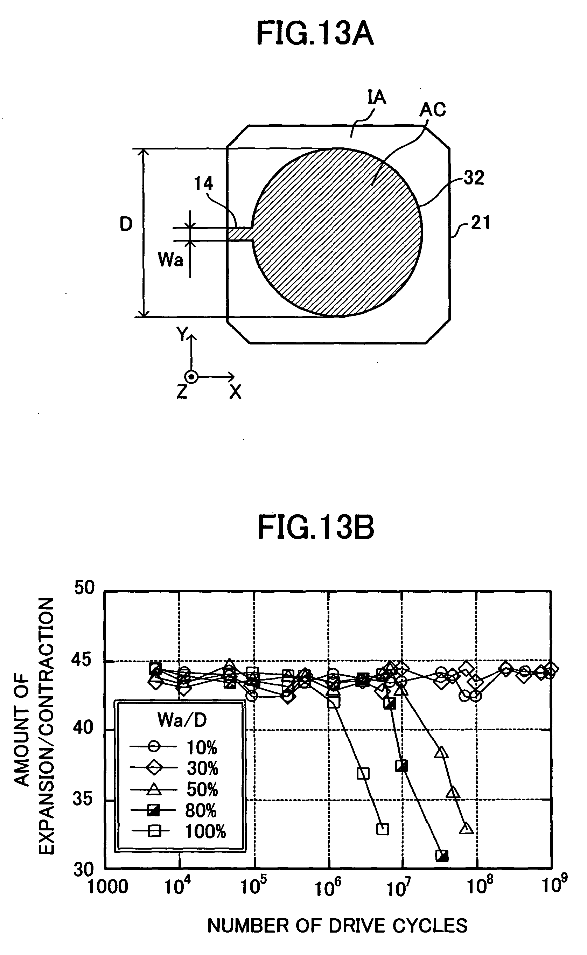

A fourth modification differs from the first embodiment only in the point that the fourth modification includes the piezoelectric body 21 and internal electrode layers 32 in place of the piezoelectric body 11 and the internal electrode layers 12 of the first embodiment (the piezoelectric/electrostrictive actuator 10), as shown in FIG. 13A, which is a cross sectional view of the piezoelectric/electrostrictive actuator of the fourth modification, taken along a plane extending along an internal electrode layer.

The piezoelectric body 21 assumes the shape as described above. Each internal electrode layer 32 is circular, and is disposed such that its centroid coincides with the centroid of the piezoelectric body 21. FIG. 13B is a graph showing changes in expansion/contraction amount of the piezoelectric body 21 with the number of drive cycles for the piezoelectric/electrostrictive actuator of the fourth modification. The marks in FIG. 13B are the same as those shown in FIG. 12B.

As is apparent from FIG. 13B, when the width Wa (Wa/D) of the electrode lead portions 14 in relation to the diameter D of the inscribed circle becomes equal to or higher than 50%, the amount of expansion and contraction decreases in a region where the number of drive cycles exceeds 10⁶. In contrast, when the width Wa of the electrode lead portions 14 in relation to the diameter D of the inscribed circle becomes equal to or less than 30%, the amount of expansion and contraction does not decrease even when the number of drive cycles reaches 10⁹. This also shows that setting the width Wa of the electrode lead portions 14 in relation to the diameter D of the inscribed circle to 30% or less is desired, from the viewpoint of improving the durability of the piezoelectric/electrostrictive actuator 10.

### (Fifth modification)

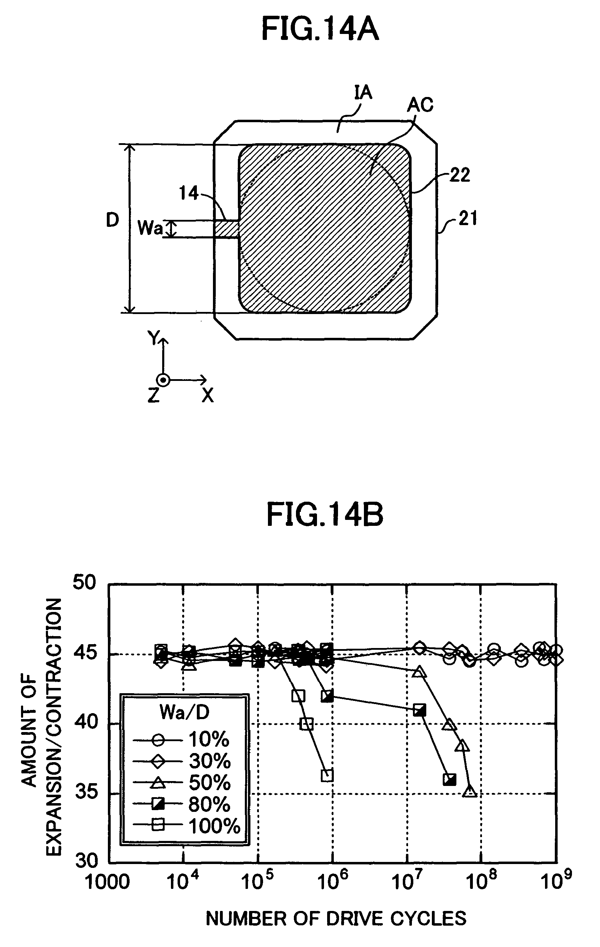

A fifth modification differs from the first embodiment only in the point that the fifth modification includes the piezoelectric body 21 and the internal electrode layers 22 in place of the piezoelectric body 11 and the internal electrode layers 12 of the first embodiment (the piezoelectric/electrostrictive actuator 10), as shown in FIG. 14A, which is a cross sectional view of the piezoelectric/electrostrictive actuator of the fifth modification, taken along a plane extending along an internal electrode layer. The piezoelectric body 21 and the internal electrode layers 22 assume the respective shapes as described above. FIG. 14B is a graph showing changes in expansion/contraction amount of the piezoelectric body 21 with the number of drive cycles for the piezoelectric/electrostrictive actuator of the fifth modification. The marks in FIG. 14B are the same as those shown in FIG. 12B.

As is apparent from FIG. 14B, when the width Wa (Wa/D) of the electrode lead portions 14 in relation to the diameter D of the inscribed circle becomes equal to or higher than 50%, the amount of expansion and contraction decreases in a region where the number of drive cycles exceeds 10⁶. In contrast, when the width Wa of the electrode lead portions 14 in relation to the diameter D of the inscribed circle becomes equal to or less than 30%, the amount of expansion and contraction does not decrease even when the number of drive cycles reaches 10⁹. This also shows that setting the width Wa of the electrode lead portions 14 in relation to the diameter D of the inscribed circle to 30% or less is desired, from the viewpoint of improving the durability of the piezoelectric/electrostrictive actuator 10.

### (Sixth modification)

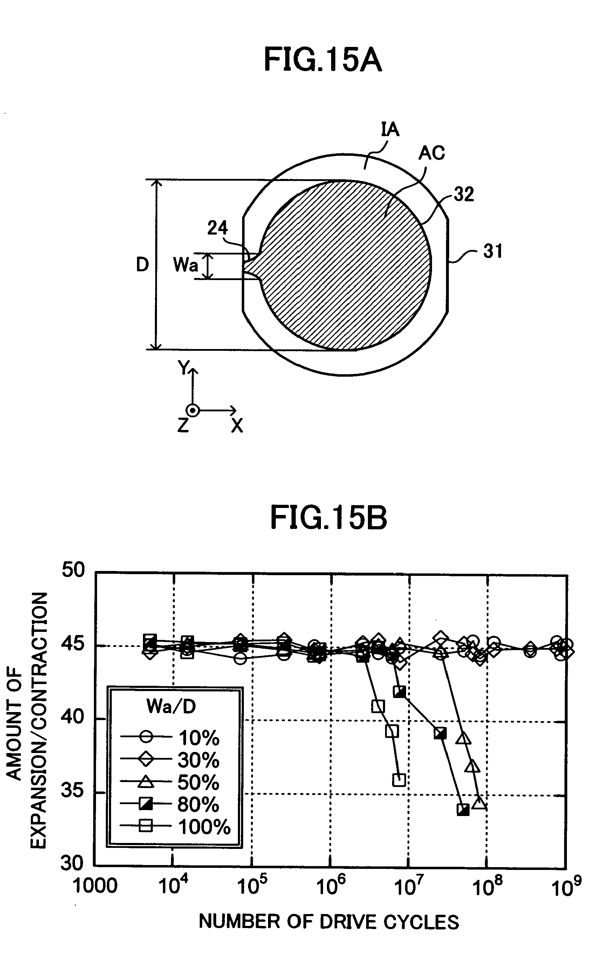

A sixth modification differs from the first embodiment only in the point that the sixth modification includes a piezoelectric body 31, the internal electrode layers 32, and the electrode lead portions 24 in place of the piezoelectric body 11, the internal electrode layers 12, and the electrode lead portions 14 of the first embodiment (the piezoelectric/electrostrictive actuator 10), as shown in FIG. 15A, which is a cross sectional view of the piezoelectric/electrostrictive actuator of the sixth modification, taken along a plane extending along an internal electrode layer. The piezoelectric body 31 assumes a generally circular outer shape, and has a pair of flat side surfaces on which side-surface electrodes are formed. The internal electrode layers 32 and the electrode lead portions 24 assume the respective shapes as described above. FIG. 15B is a graph showing changes in expansion/contraction amount of the piezoelectric body 31 with the number of drive cycles for the piezoelectric/electrostrictive actuator of the sixth modification. The marks in FIG. 15B are the same as those shown in FIG. 12B.

As is apparent from FIG. 15B, when the width Wa (Wa/D) of the electrode lead portions 24 in relation to the diameter D of the inscribed circle becomes equal to or higher than 50%, the amount of expansion and contraction decreases in a region where the number of drive cycles exceeds 10⁶. In contrast, when the width Wa of the electrode lead portions 24 in relation to the diameter D of the inscribed circle becomes equal to or less than 30%, the amount of expansion and contraction does not decrease even when the number of drive cycles reaches 10⁹. This also shows that setting the width Wa of the electrode lead portions 24 in relation to the diameter D of the inscribed circle to 30% or less is desired, from the viewpoint of improving the durability of the piezoelectric/electrostrictive actuator 10.

### (Seventh modification)

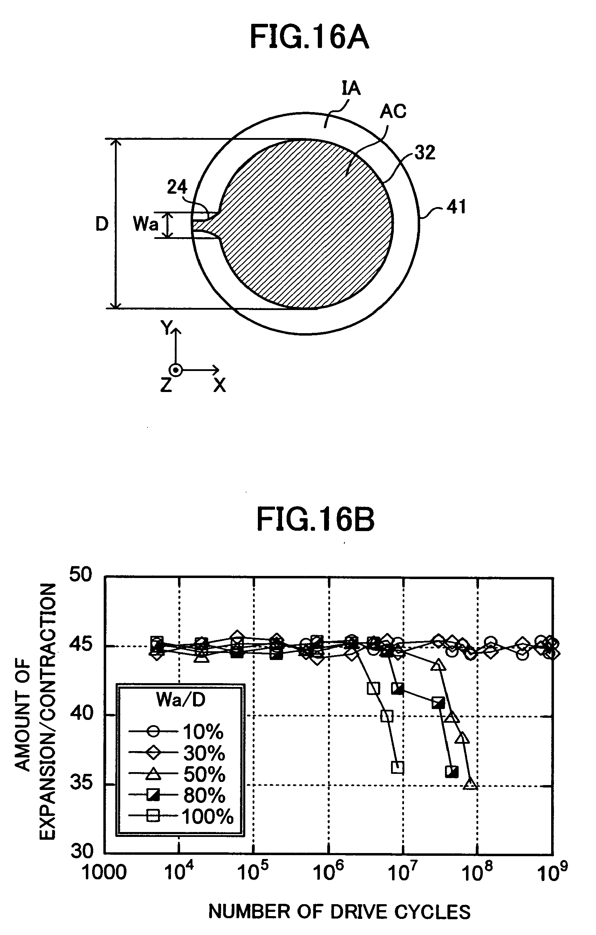

A seventh modification differs from the first embodiment only in the point that the seventh modification includes a piezoelectric body 41, the internal electrode layers 32, and the electrode lead portions 24 in place of the piezoelectric body 11, the internal electrode layers 12, and the electrode lead portions 14 of the first embodiment (the piezoelectric/electrostrictive actuator 10), as shown in FIG. 16A, which is a cross sectional view of the piezoelectric/electrostrictive actuator of the seventh modification, taken along a plane extending along an internal electrode layer. The piezoelectric body 41 assumes a circular outer shape. The internal electrode layers 32 and the electrode lead portions 24 assume the respective shapes as described above. FIG. 16B is a graph showing changes in expansion/contraction amount of the piezoelectric body 41 with the number of drive cycles for the piezoelectric/electrostrictive actuator of the seventh modification. The marks in FIG. 16B are the same as those shown in FIG. 12B.

As is apparent from FIG. 16B, when the width Wa (Wa/D) of the electrode lead portions 24 in relation to the diameter D of the inscribed circle becomes equal to or higher than 50%, the amount of expansion and contraction decreases in a region where the number of drive cycles exceeds 10⁶. In contrast, when the width Wa of the electrode lead portions 24 in relation to the diameter D of the inscribed circle becomes equal to or less than 30%, the amount of expansion and contraction does not decrease even when the number of drive cycles reaches 10⁹. This also shows that setting the width Wa of the electrode lead portions 24 in relation to the diameter D of the inscribed circle to 30% or less is desired, from the viewpoint of improving the durability of the piezoelectric/electrostrictive actuator 10.

### (Eighth modification)

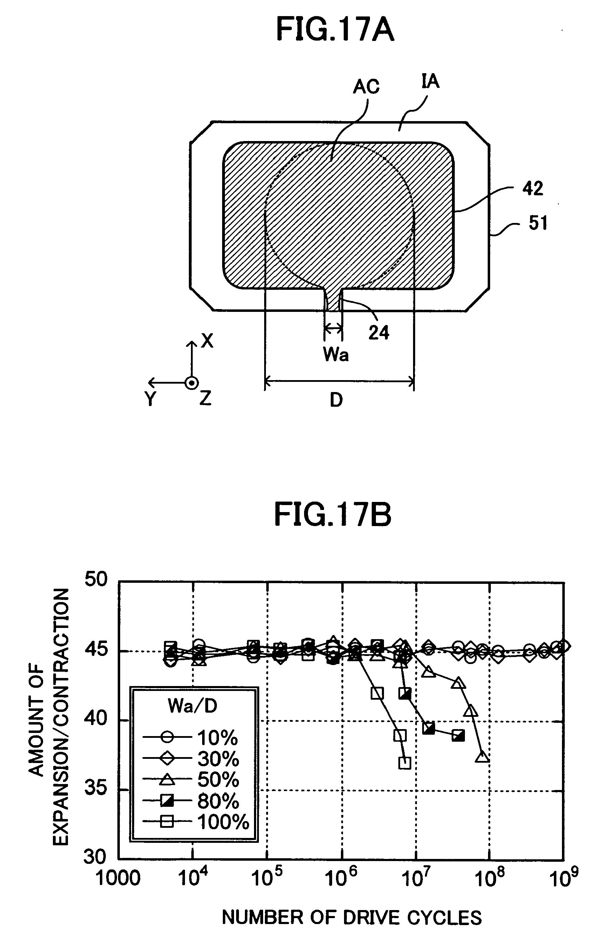

An eighth modification differs from the first embodiment only in the point that the eighth modification includes a piezoelectric body 51, internal electrode layers 42, and the electrode lead portions 24 in place of the piezoelectric body 11, the internal electrode layers 12, and the electrode lead portions 14 of the first embodiment (the piezoelectric/electrostrictive actuator 10), as shown in FIG. 17A, which is a cross sectional view of the piezoelectric/electrostrictive actuator of the eighth modification, taken along a plane extending along an internal electrode layer. The piezoelectric body 51 assumes an octagonal outer shape obtained by chamfering corner portions of a rectangle. Each internal electrode layer 42 has a rectangular shape slightly smaller than the outer shape of the piezoelectric body 51 and its corners are rounded. The four sides of each internal electrode layer 42 are parallel to the corresponding sides of the piezoelectric body 51, and the centroid of the internal electrode layer 42 coincides with the centroid of the piezoelectric body 51. Each electrode lead portion 24 has the shape as described above. FIG. 17B is a graph showing changes in expansion/contraction amount of the piezoelectric body 51 with the number of drive cycles for the piezoelectric/electrostrictive actuator of the eighth modification. The marks in FIG. 17B are the same as those shown in FIG. 12B.

As is apparent from FIG. 17B, when the width Wa (Wa/D) of the electrode lead portions 24 in relation to the diameter D of the inscribed circle (in this case, a circle inscribed to a pair of longer sides of the rectangle) to becomes equal to or higher than 50%, the amount of expansion and contraction decreases in a region where the number of drive cycles exceeds 10⁶. In contrast, when the width Wa of the electrode lead portions 24 in relation to the diameter D of the inscribed circle becomes equal to or less than 30%, the amount of expansion and contraction does not decrease even when the number of drive cycles reaches 10⁹. This also shows that setting the width Wa of the electrode lead portions 24 in relation to the diameter D of the inscribed circle to 30% or less is desired, from the viewpoint of improving the durability of the piezoelectric/electrostrictive actuator 10.

### (Ninth modification)

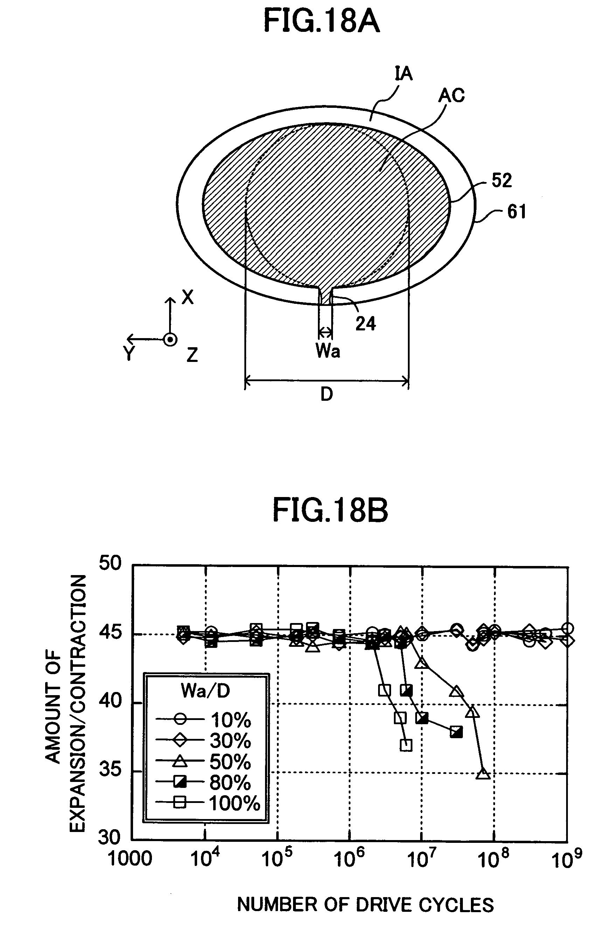

A ninth modification differs from the first embodiment only in the point that the ninth modification includes a piezoelectric body 61, internal electrode layers 52, and the electrode lead portions 24 in place of the piezoelectric body 11, the internal electrode layers 12, and the electrode lead portions 14 of the first embodiment (the piezoelectric/electrostrictive actuator 10), as shown in FIG. 18A, which is a cross sectional view of the piezoelectric/electrostrictive actuator of the ninth modification, taken along a plane extending along an internal electrode layer. The piezoelectric body 61 assumes an elliptical outer shape. Each internal electrode layer 52 has an elliptical outer shape slightly smaller than the outer shape of the piezoelectric body 61, and the major and minor axes of the internal electrode layer 52 coincide (overlap) with the major and minor axes of the piezoelectric body 61. Each electrode lead portion 24 has the shape as described above. FIG. 18B is a graph showing changes in expansion/contraction amount of the piezoelectric body 61 with the number of drive cycles for the piezoelectric/electrostrictive actuator of the ninth modification. The marks in FIG. 18B are the same as those shown in FIG. 12B.

As is apparent from FIG. 18B, when the width Wa (Wa/D) of the electrode lead portions 24 in relation to the diameter D of the inscribed circle (in this case, a circle inscribed to a pair of arcs formed by cutting an ellipse along the major axis thereof) becomes equal to or higher than 50%, the amount of expansion and contraction decreases in a region where the number of drive cycles exceeds 10⁶. In contrast, when the width Wa of the electrode lead portions 24 in relation to the diameter D of the inscribed circle becomes equal to or less than 30%, the amount of expansion and contraction does not decrease even when the number of drive cycles reaches 10⁹. This also shows that setting the width Wa of the electrode lead portions 24 in relation to the diameter D of the inscribed circle to 30% or less is desired, from the viewpoint of improving the durability of the piezoelectric/electrostrictive actuator 10.

### (Other modifications)

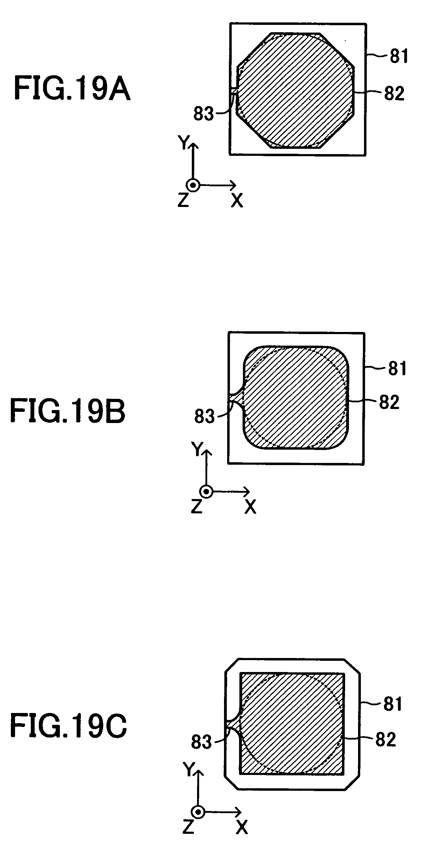

The piezoelectric body and the internal electrode layers of the present embodiment may be formed to assume various shapes as shown in FIGS. 19 to 21 in addition to those of the above-described modifications. Note that, in any of the embodiment and the modifications, the internal electrode layers have a higher degree of symmetry than does the piezoelectric body. The features of the shapes (shapes as shown from above) of the piezoelectric bodies and the internal electrode layers shown in these drawings will be described. In these drawings, the piezoelectric body, the internal electrode layers, the electrode lead portions, and the side-surface electrodes are denoted by reference numerals 81, 82, 83, and 84, respectively.

FIG. 19A: The piezoelectric body 81 is in the form of a square; and each internal electrode layer 82 is in the form of a regular octagon (shape of 8-fold symmetry).

FIG. 19B: The piezoelectric body 81 is in the form of a square; and each internal electrode layer 82 is in the form of a square having rounded corners.

FIG. 19C: The piezoelectric body 81 is in the form of an octagon obtained by chamfering the corners of a square; and each internal electrode layer 82 is in the form of a square.

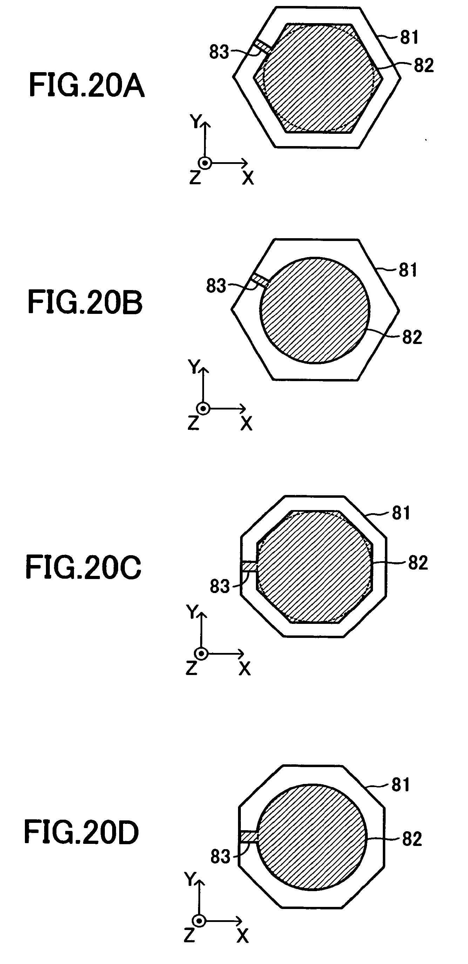

FIG. 20A: The piezoelectric body 81 is in the form of a regular hexagon; and each internal electrode layer 82 is in the form of a regular hexagon slightly smaller than the outer shape of the piezoelectric body 81.

FIG. 20B: The piezoelectric body 81 is in the form of a regular hexagon; and each internal electrode layer 82 is in the form of a circle.

FIG. 20C: The piezoelectric body 81 is in the form of a regular octagon; and each internal electrode layer 82 is in the form of a regular octagon slightly smaller than the outer shape of the piezoelectric body 81.

FIG. 20D: The piezoelectric body 81 is in the form of a regular octagon; and each internal electrode layer 82 is in the form of a circle.

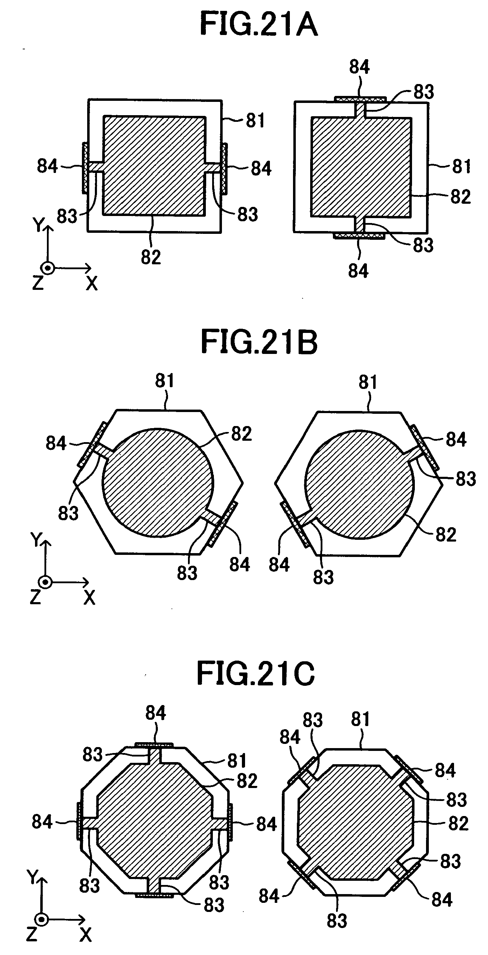

A pair of internal electrode layers 82 shown in FIG. 21A are those facing each other. The piezoelectric body 81 is a rectangular shape as viewed from above. Each internal electrode layer 82 has a rectangular planar shape; and is connected to a pair of electrode lead portions 83, which extend along a straight line passing through the centroid of the internal electrode layer 82 as viewed from above. The extending direction of the electrode lead portions 83 connected to one internal electrode layer 82 perpendicularly intersects with the extending direction of the electrode lead portions 83 connected to the other internal electrode layer 82.

A pair of internal electrode layers 82 shown in FIG. 21B are those facing each other. The piezoelectric body 81 is a regular hexagonal shape as viewed from above. Each internal electrode layer 82 has a circular planar shape; and is connected to a pair of electrode lead portions 83, which extend along a straight line passing through the centroid of the internal electrode layer 82 as viewed from above. The extending direction of the electrode lead portions 83 connected to one internal electrode layer 82 intersects by 60 degrees with respect to the extending direction of the electrode lead portions 83 connected to the other internal electrode layer 82.

A pair of internal electrode layers 82 shown in FIG. 21C are those facing each other. The piezoelectric body 81 is a regular octagonal shape as viewed from above. Each internal electrode layer 82 has a regular octagonal planar shape; and is connected to four electrode lead portions 83, which extend along two straight lines perpendicularly intersecting each other and passing through the centroid of the internal electrode layer 82 as viewed from above. The extending directions of the electrode lead portions 83 connected to one internal electrode layer 82 are intersects by 45 degrees with respect to the extending directions of the electrode lead portions 83 connected to the other internal electrode layer 82.

As described above, the shape (shape as viewed from above, or shape in a plane perpendicularly intersecting the thickness direction) of each internal electrode layer may be a shape having n-fold symmetry, where n is an integer not less than 2, a rectangular shape, an oval shape or an elliptical shape. The "n-fold symmetry" means that, if an original shape is rotated by 360/n degrees (360° divided by an integer n), the rotated shape is identical to the original shape. In other words, a shape has "n-fold symmetry", if the shape rotated by 360/n degrees from an original position can be identical to the shape which stays at the original position. Since the shape of the internal electrodes has a high degree of symmetry, there can be provided a piezoelectric/electrostrictive actuator in which distortion generated in the active portion is efficiently used in expansion and contraction in a desired expansion/contraction direction (in this case, Z-axis direction), and excessive stress is not generated.

### Second Embodiment:

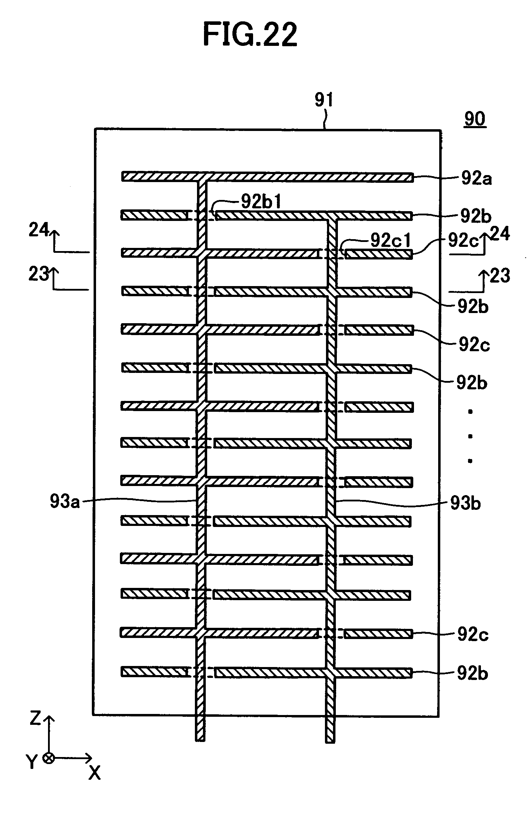

A piezoelectric/electrostrictive actuator 90 according to a second embodiment will be described with reference to FIGS. 22 to 24. The piezoelectric/electrostrictive actuator 90 includes a piezoelectric body 91 generally identical to the piezoelectric body 11; internal electrode layers 92a, 92b, and 92c; and electrode lead portions 93a and 93b.

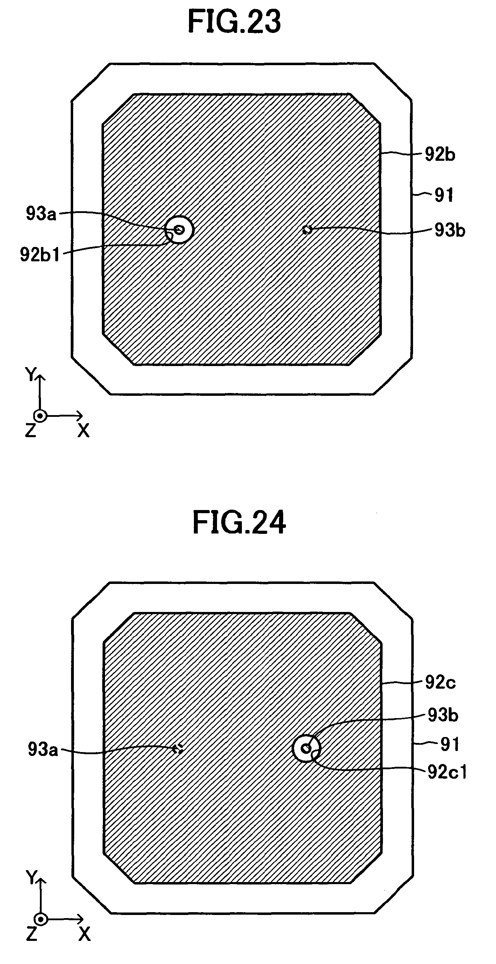

Each of the internal electrode layers 92a, 92b, and 92c is substantially the same as the internal electrode layers 12. However, as shown in FIG. 23, each internal electrode layer 92b has a through hole 92b1 through which the electrode lead portion 93a passes in the Z-axis direction. As shown in FIG. 24, each internal electrode layer 92c has a through hole 92c1 through which the electrode lead portion 93b passes in the Z-axis direction. The internal electrode layer 92a is disposed at the top portion of the piezoelectric body 91, and the internal electrode layers 92b and 92c are alternately disposed toward the lower end of the piezoelectric body 91.

The electrode lead portion 93a extends from the lower end of the piezoelectric body 91 into the interior of the piezoelectric body 91 in the Z-axis positive direction, is connected to the internal electrode layers 92c, while passing through the through holes 92b1 formed in the internal electrode layers 92b, and is finally connected to the internal electrode layer 92a. The spaces between the electrode lead portion 93a and the wall surfaces of the through holes 92b1 are filled with an insulating material (in the present example, the piezoelectric body 91).

The electrode lead portion 93b extends from the lower end of the piezoelectric body 91 into the interior of the piezoelectric body 91 in the Z-axis positive direction, is connected to the internal electrode layer 92b in the lower end portion, is further connected to a plurality of the internal electrode layers 92b, while passing through the through holes 92c1 formed in the internal electrode layers 92c, and is finally connected to the uppermost internal electrode layer 92b. The spaces between the electrode lead portion 93b and the wall surfaces of the through holes 92c1 are filled with an insulating material (in the present example, the piezoelectric body 91).

With this structure, as can be seen from FIGS. 23 and 24, the electrode lead portions do not extend on the same planes as the internal electrode layers as in the case of the first embodiment. Therefore, an inactive portion can be formed to surround an active portion (central portion) without fail.

By the way, when a crack arises in the piezoelectric body of the piezoelectric/electrostrictive actuator, in which the internal electrode layers 12 are connected to the side-surface electrodes 13, as the first embodiment, the crack may progresses and causes the side-surface electrodes 13 to crack. If the side-surface electrodes 13 cracks, there may be one or more internal electrode layers 12 to which the predetermined voltages can not be applied.

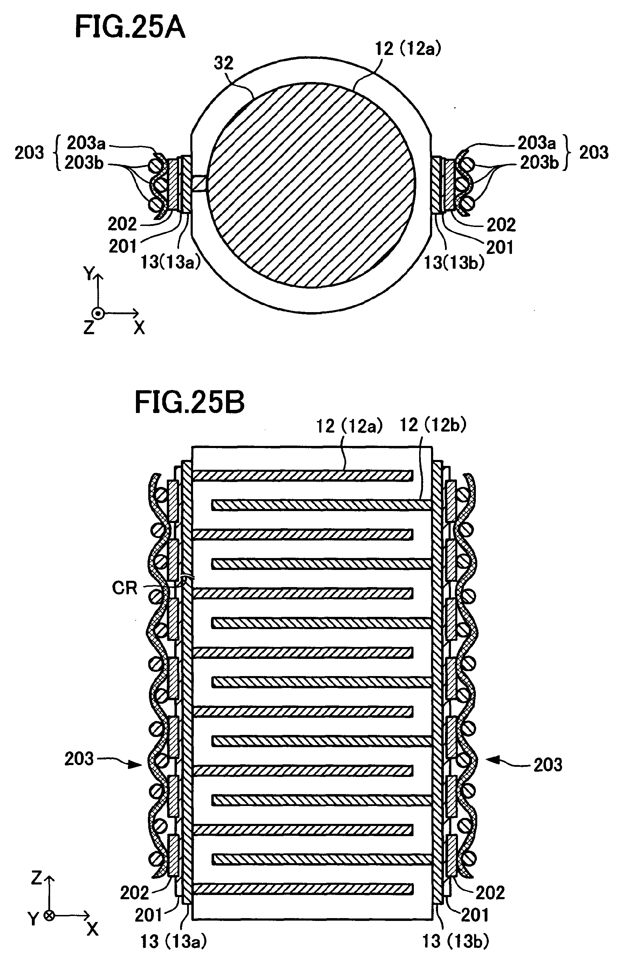

Therefore, in actuality, as shown in FIGS 25A and 25B, first supplemental electrodes 202 are fixed to the side-surface electrodes 13 (13a, 13b) through a solder layers 201. Each of the solder layers 201 is formed on each of the substantially entire surfaces of the side-surface electrodes 13. The first supplemental electrode 202 is a thin film electrode having a small thickness in the X-axis direction. The length of the first supplemental electrode 202 along the Y-axis direction is about the same as that of the side-surface electrodes 13 along the Y-axis direction.

Second supplemental electrodes 203 are fixed to and contacted with the first supplemental electrodes 202. Each of the second supplemental electrodes 203 is a mesh-like electrode having elasticity. Therefore, a plurality of the internal electrode layers 12a (or a plurality of the internal electrode layers 12b) is electrically connected to one another through not only one of the side-surface electrodes 13 but also one supplemental electrode which includes one of the solder layers 201, one of the first supplemental electrodes 202, and one of the second supplemental electrodes 203. As a result, for example, even when the side-surface electrodes 13a has a crack CR and becomes broken, the predetermined voltage is applied to all of internal electrode layers 12a through the supplemental electrode.

On the other hand, a piezoelectric/electrostrictive actuator which has higher reliability and can be more easily implemented is provided by manufacturing through "a simultaneous punching-laminating method" the piezoelectric/electrostrictive actuator in which a plurality of the internal electrode layers 92c are connected by the electrode lead portion 93a passing through the interior of the piezoelectric body 91 and a plurality of the internal electrode layers 92b are connected by the electrode lead portion 93b passing through the interior of the piezoelectric body 91, as the piezoelectric/electrostrictive actuator 90 shown in FIG. 22. Hereinafter, the piezoelectric/electrostrictive actuator manufactured by "the simultaneous punching-laminating method" will be described.

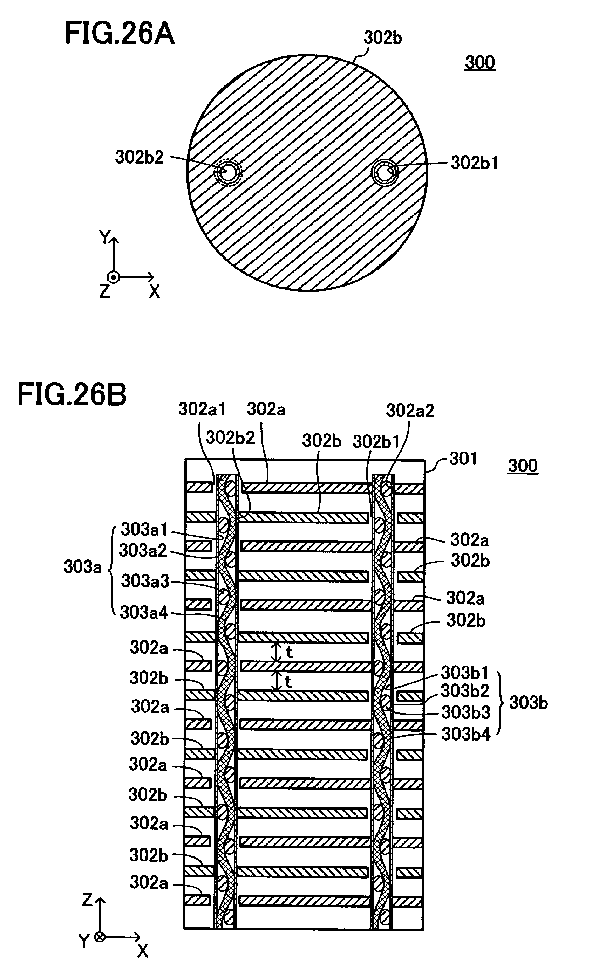

FIG. 26A is a cross sectional view of the piezoelectric/electrostrictive actuator 300 manufactured by "the simultaneous punching-laminating method", taken along a plane extending along an internal electrode layer. FIG. 26B is a vertical cross-sectional view of the actuator 300. The piezoelectric/electrostrictive actuator 300 includes a piezoelectric body 301, a plurality of internal electrode layers 302a, a plurality of internal electrode layers 302b, an electrode lead portion 303a, and an electrode lead portion 303b.

The piezoelectric body 301 is a piezoelectric body similar to the piezoelectric body 41 whose outer shape is a circular column.

Each of the internal electrode layers 302a is an internal electrode layer similar to the internal electrode layer 92b and formed on a plane along the X-Y plane. The diameter of the each of the internal electrode layers 302a is equal to the diameter of the piezoelectric body 301. That is, an outer circumference of each of the internal electrode layers 302a is exposed to the side surface of the piezoelectric/electrostrictive actuator 300. Each of the internal electrode layers 302a has a cylindrical through hole 302a1 and a cylindrical through hole 302a2. The radius of the through hole 302a1 is slightly larger than the radius of the through hole 302a2.

Each of the internal electrode layers 302b is an internal electrode layer similar to the internal electrode layer 92c and formed on a plane along the X-Y plane. The diameter of the each of the internal electrode layers 302b is equal to the diameter of the piezoelectric body 301. That is, an outer circumference of each of the internal electrode layers 302b is exposed to the side surface of the piezoelectric/electrostrictive actuator 300. Each of the internal electrode layers 302b has a cylindrical through hole 302b1 and a cylindrical through hole 302b2. The radius of through hole 302b1 is slightly larger than the radius of the through hole 302b2.

The internal electrode layers 302a and the internal electrode layers 302b are alternately disposed along the Z-axis direction such that one of the internal electrode layers 302a and one of the internal electrode layers 302b face each other. The distance between one of the internal electrode layer 302a and one of the internal electrode layer 302b adjacent to that one of the internal electrode layer 302a (i.e., the thickness t of a single layer of the piezoelectric body) is constant.

The electrode lead portion 303a includes a hollow cylindrical section 303a1, a layer electrode section 303a2, conductive elastic members 303a3, and a mesh-like electrode 303a4.

The hollow cylindrical section 303a1 is a space that is formed inside of the piezoelectric body 301 and has a hollow cylindrical shape. The hollow cylindrical section 303a1 has a center axis extending along the Z-axis. The hollow cylindrical section 303a1 is in communication with the bottom surface of the piezoelectric body 301 to form an opening on the bottom surface. The center axis of the hollow cylindrical section 303a1, and a center axis of each of the larger through holes 302a1 of the internal electrode layers 302a, and a center axis of each of the smaller through holes 302b2 of the internal electrode layers 302b are on a single straight line. The radius of the hollow cylindrical section 303a1 is smaller than the radius of the larger through hole 302a1 of the internal electrode layers 302a, and is equal to the radius of the smaller through hole 302b2 of the internal electrode layers 302b. The spaces between the hollow cylindrical section 303a1 and the larger through holes 302a1 of the internal electrode layers 302a are filled with an insulating material (which is, in the present example, the piezoelectric body 301).

The layer electrode section 303a2 is a conductive thin film formed on an inside wall surface that defines the hollow cylindrical section 303a1. The layer electrode section 303a2 is connected with the internal electrode layers 302b physically and electrically.

The conductive elastic members 303a3 and the mesh-like electrode 303a4 are inserted into the hollow cylindrical section 303a1. The conductive elastic members 303a3 and the mesh-like electrode 303a4 form a cylindrical member which tends to expand its diameter when it is inserted into the hollow cylindrical section 303a1. That is, the conductive elastic members 303a3 act to expand the mesh-like electrode 303a4. Further, the mesh-like electrode 303a4 and the layer electrode section 303a2 are fixed each other through solder layers not shown. As a result, the mesh-like electrode 303a4 is electrically connected with the layer electrode section 303a2 steadily.

Similarly, the electrode lead portion 303b includes a hollow cylindrical section 303b1, a layer electrode section 303b2, conductive elastic members 303b3, and a mesh-like electrode 303b4.

The hollow cylindrical section 303b1 is a space that is formed inside of the piezoelectric body 301 and has a hollow cylindrical shape. The hollow cylindrical section 303b1 has a center axis extending along the Z-axis. The center axis of the hollow cylindrical section 303b1 keeps away from the center axis of the hollow cylindrical section 303a1 by a predetermined distance. The radius of the hollow cylindrical section 303b1 is equal to the radius of the hollow cylindrical section 303a1. The hollow cylindrical section 303b1 is in communication with the bottom surface of the piezoelectric body 301 to form an opening on the bottom surface. The center axis of the hollow cylindrical section 303b1, and a center axis of each of the larger through holes 302b1 of the internal electrode layers 302b, and a center axis of each of the smaller through holes 302a2 of the internal electrode layers 302a are on a single straight line. The radius of the hollow cylindrical section 303b1 is smaller than the radius of the larger through hole 302b1 of the internal electrode layers 302b, and is equal to the radius of the smaller through hole 302a2 of the internal electrode layers 302a. The spaces between the hollow cylindrical section 303b1 and the larger through hole 302b1 of the internal electrode layers 302b are filled with an insulating material (which is, in the present example, the piezoelectric body 301).

The layer electrode section 303b2 is a conductive thin film formed on the inside wall surface that defines the hollow cylindrical section 303b1. The layer electrode section 303b2 is connected with the internal electrode layers 302a physically and electrically.

The conductive elastic members 303b3 and the mesh-like electrode 303b4 are inserted into the hollow cylindrical section 303b1. The conductive elastic members 303b3 and the mesh-like electrode 303b4 form a cylindrical member which tends to expand its diameter when it is inserted into the hollow cylindrical section 303b1. That is, the conductive elastic members 303b3 act to expand the mesh-like electrode 303b4. Further, the mesh-like electrode 303b4 and the layer electrode section 303b2 are fixed each other through solder layers now shown. As a result, the mesh-like electrode 303b4 is electrically connected with the layer electrode section 303b2 steadily.

The piezoelectric/electrostrictive actuator 300 having a construction described above expands and contracts along the Z-axis by applying the predetermined voltage to the internal electrode layers 302b and the internal electrode layers 302a through the layer electrode section 303a2 and the layer electrode section 303b2, respectively.

In addition, even when the layer electrode section 303a2 has a crack and becomes broken, a plurality of the internal electrode layers 302b are kept in the conduction state one another through the mesh-like electrode 303a4. Likewise, even when the layer electrode section 303b2 has a crack and becomes broken, a plurality of the internal electrode layers 302a are kept in the conduction state one another through the mesh-like electrode 303b4. As a result, the predetermined voltage is applied to the internal electrode layers 302a and the internal electrode layers 302b, even when the layer electrode section 303a2 and/or the layer electrode section 303b2 have a crack.

### (The individual-punching and laminating method)

Next, the simultaneous punching-laminating method for manufacturing the piezoelectric/electrostrictive actuator 300 is described by comparing with a conventional individual-punching and laminating method. The piezoelectric/electrostrictive actuator 300 can be manufactured by the conventional individual-punching and laminating method as well. However, manufacturing the piezoelectric/electrostrictive actuator 300 by the simultaneous punching-laminating method can yield a lot of advantages described later in detail.

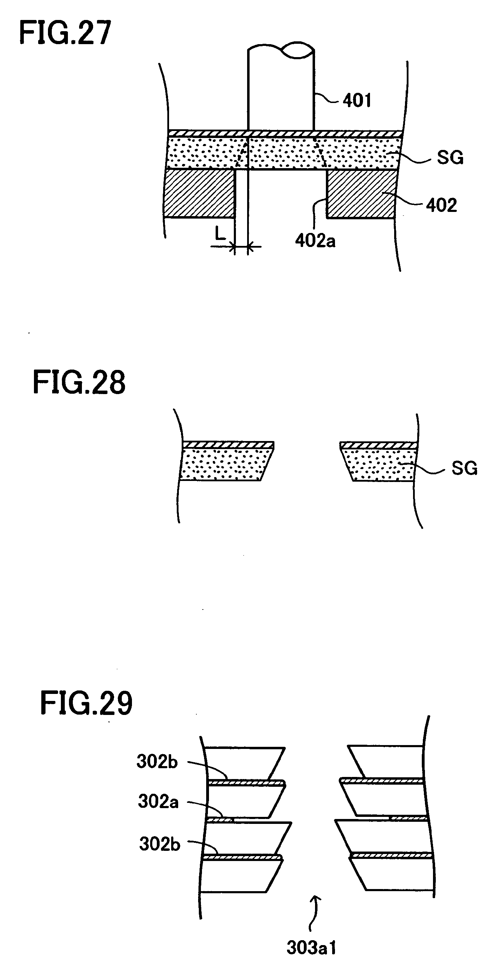

First, the conventional individual-punching and laminating method is described. In the individual-punching and laminating method, a cylindrical punch 401 and a die 402 are prepared as shown in FIG. 27. These are used to make circular (cylindrical) through holes that will become the hollow cylindrical sections 303a1 and 303b1. The die 402 has a through hole 402a through which the punch 401 passes. Generally, the radius of the through hole 402a is larger than the radius of the punch 401 by a distance L. That is, a clearance L is provided between the punch 401 and the die 402.

Meanwhile, a layer which will be the internal electrode layers 302a (or the internal electrode layers 302b) is formed on a piezoelectric ceramics green sheet by printing and the like. At the same time, the through holes 302a1 and 302a2 (or the through holes 302b1 and 302b2) are formed. Next, the piezoelectric ceramics green sheet SG is disposed on the die 402, and is punched out using the cylindrical punch 401. When punching, as shown by the dotted line in FIG. 27, a crack occurs from each of the edges of the punch 401 and the die 402. As a result, as shown in FIG. 28, cross-sectional shape of the thus-formed through hole has a tapered shape whose diameter increases with respect to the punching out direction.

With the method described above, a plurality of the ceramics green sheets having through holes are formed separately. The sheets are moved to the different place and thereafter laminated and fired (burnt). Next, the layer electrode sections 303a2 and 303b2 are formed by plating or dipping in the hollow cylindrical sections 303a1 and 303b1. Thereafter, the conductive elastic members 303a3 and the mesh-like electrode 303a4 are inserted into the hollow cylindrical section 303a1 and are fixed to the layer electrode sections 303a2 by soldering. In a similar fashion, the conductive elastic members 303b3 and the mesh-like electrode 303b4 are inserted into the hollow cylindrical section 303b1 and are fixed to the layer electrode sections 303b2 by soldering. Through the processes described above, the piezoelectric/electrostrictive actuator 300 is manufactured

FIG. 29 is an enlarged sectional view of the hollow cylindrical section 303a1 of the piezoelectric/electrostrictive actuator 300 manufactured by the method described above. As mentioned above, the through hole of each of the ceramics green sheets SG has tapered shape. Therefore, the inside wall surface of the thus-manufactured hollow cylindrical section 303a1 is not flat due to the tapered shape. This may cause a sharp corner to exist at a boundary portion between one layer of the piezoelectric body and another layer adjacent to that one layer of the piezoelectric body (these layers are integrated by the firing). As a result, a crack may be initiated from the sharp corner in the layer of the piezoelectric body.

### (The simultaneous punching-laminating method)

Next, the method for manufacturing the piezoelectric/electrostrictive actuator 300 using the simultaneous punching-laminating method is described. Note that the simultaneous punching-laminating method is described in detail by Japanese Patent Application Laid-Open (kokai) No. 2002-160195, which is incorporated here by reference.

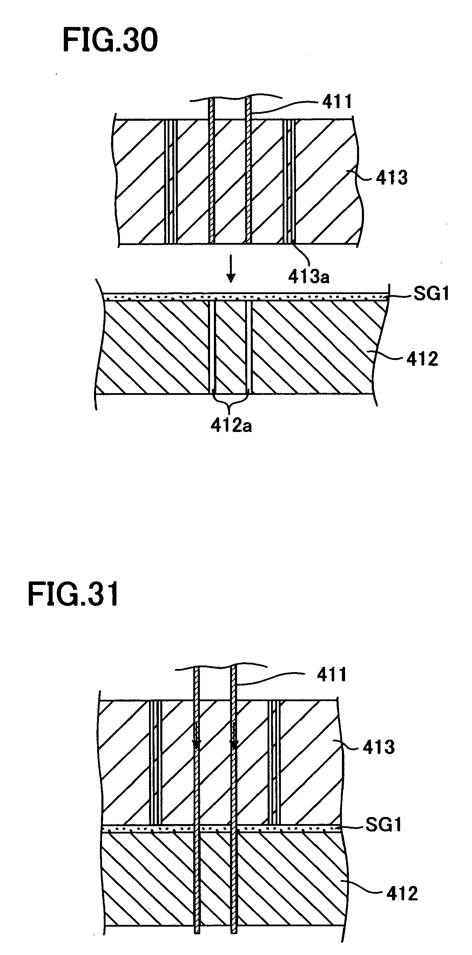

In the simultaneous punching-laminating method, a punch 411, a die 412, and a stripper 413 shown in FIG. 30 are used to form circular (cylindrical) through holes that will become the hollow cylindrical sections 303a1 and 303b1.

Initially, the first piezoelectric ceramics green sheet SG1 is disposed on the die 412. Note that a layer which will be the internal electrode layer 302a (or the internal electrode layer 302b) has been formed on the sheet SG1 by printing and the like. The through holes 302a1 and 302a2 (or the through holes 302b1 and 302b2) have also been formed.

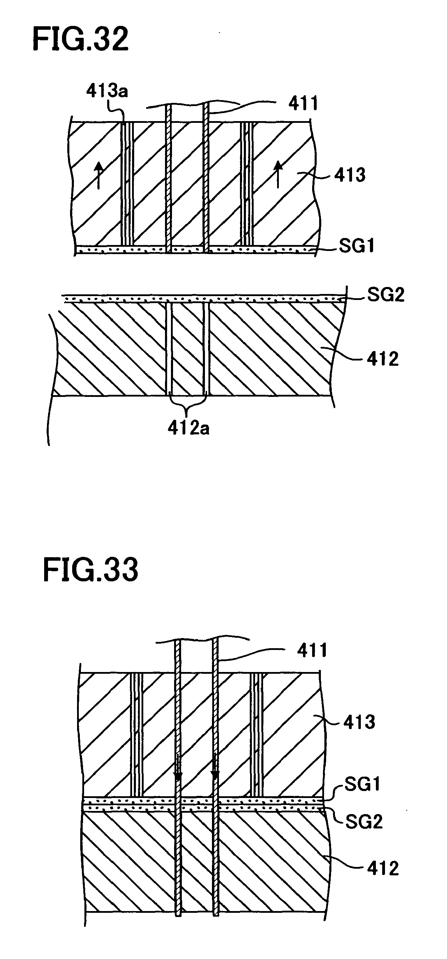

Next, as shown in FIG. 31, the ceramics green sheet SG1 is punched out by using punch 411 having a pair of cylindrical portions. Thereafter, as shown in FIG. 32, the ceramics green sheet SG1 is moved upward together with punch 411 while the ceramics green sheet SG1 is appressed to the stripper 413 without pulling out the punch 411 from the ceramics green sheet SG1. For example, the ceramics green sheet SG1 is appressed to the stripper 413 by suction using through holes 413a formed in the stripper 413. When the ceramics green sheet SG1 is moved upward, a head of the punch 411 (ends of the cylindrical portions) is disposed at a position lower than a center of each of the through holes formed in the ceramics green sheet SG1 along the axis of each of the through holes. That is, the punch 411 is kept inserted in the ceramics green sheet SG1 at a position where the punch 411 is pulled slightly upward (i.e., pulling out direction) from the bottom surface of the ceramics green sheet SG1.

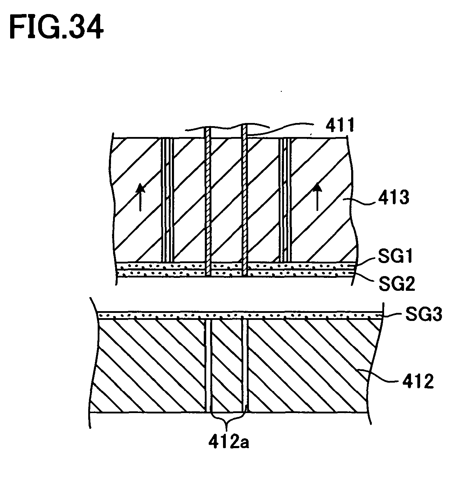

Next, as shown in FIG. 32, the second piezoelectric ceramics green sheet SG2 is disposed on the die 412. Note that, as the first sheet SG1, a layer which will be the internal electrode layer has been formed on the sheet SG2 by printing and the like. The through holes 302a1 and 302a2 (or the through holes 302b1 and 302b2) have also been formed. Then, as shown in FIG. 33, the punch 411, the stripper 413, and the first piezoelectric ceramics green sheet SG1 are moved downward to punch out the second piezoelectric ceramics green sheet SG2 by the punch 411. Thereafter, as shown in FIG. 34, the ceramics green sheets SG1 and SG2 are moved upward together with the punch 411 and the stripper 413 without pulling out the punch 411 from the ceramics green sheets SG1 and SG2.

By repeating the processes described above, a required number of the ceramics green sheets are laminated while forming through holes by punching in the ceramics green sheets simultaneously. When laminating and forming the through holes for the required number of the ceramics green sheets are completed, the punch 411 is pulled out from the laminated ceramics green sheets. The laminated ceramics green sheets are moved to a different place to be fired. Thereafter, with a method similar to the method described above, the layer electrode sections 303a2 and 303b2 are formed. Then, the conductive elastic members 303a3 and the mesh-like electrode 303a4 are fixed to the layer electrode sections 303a2 by soldering, the conductive elastic members 303b3 and the mesh-like electrode 303b4 are fixed to the layer electrode sections 303b2 by soldering. Through the processes described above, the piezoelectric/electrostrictive actuator 300 is manufactured

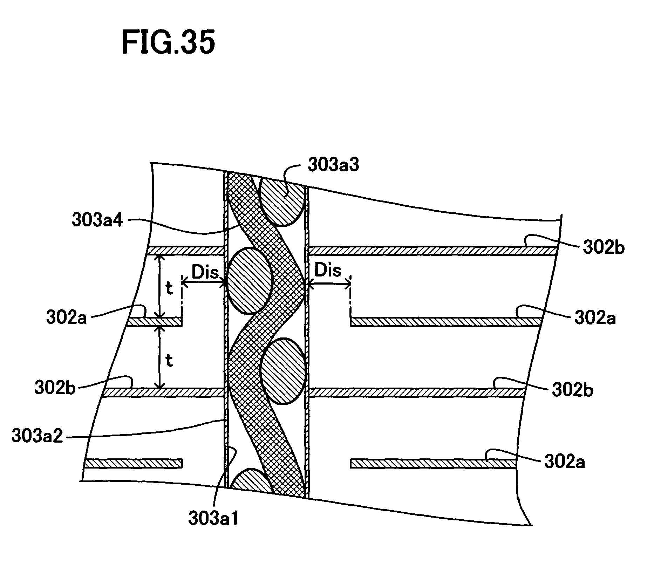

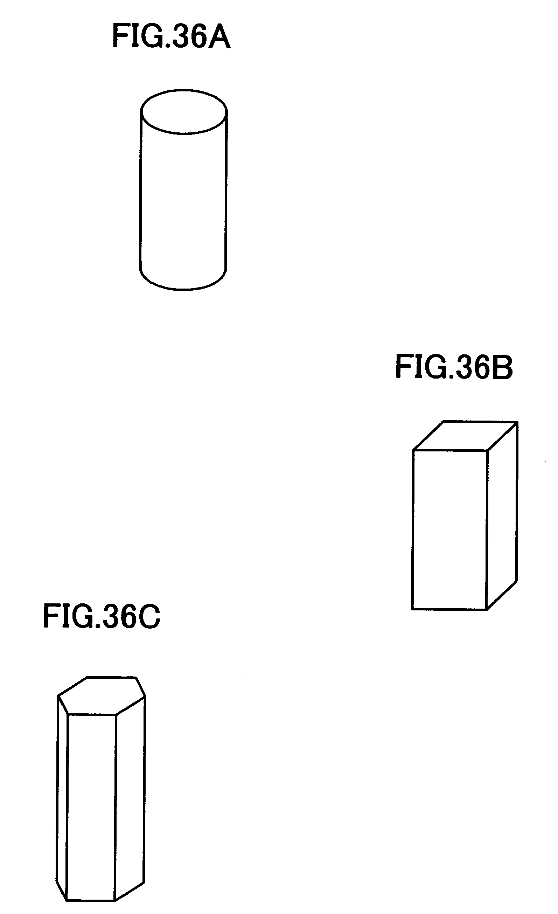

The piezoelectric/electrostrictive actuator 300 manufactured by the simultaneous punching-laminating method provides advantages described below. Note that, hereinafter, the description is made with respect to the hollow cylindrical section 303a1, however, the same is true for the hollow cylindrical section 303b1.
(1) The wall surface of the hollow cylindrical section 303a1 formed using the simultaneous punching-laminating method has extremely high flatness (See FIG. 35) compared to the wall surface of the hollow cylindrical section 303a1 formed using the individual-punching and laminating method (See FIG. 29). It is inferred that this is because an axis of the through hole formed in each of the ceramics green sheets can agree to one another (or the axes of the through holes can be aligned) accurately, since the ceramics green sheets are laminated while forming through holes without pulling out the punch 411 from the ceramics green sheets. Further, it is inferred that this is because the punch 411 reciprocates in the through holes when forming new through holes in a successive ceramics green sheet that has not been punched out, and thus, the movement of the punch 411 makes the inside wall of the through holes flatter. That is, the flatness level of the wall surface of the hollow cylindrical section 303a1 formed using the simultaneous punching-laminating method is even equal to the flatness level of a wall surface polished by grinding process (or machining process). Therefore, sharp corners are very unlikely to be made at the boundary portions, the portion being between one layer of the piezoelectric body and another layer adjacent to that one layer of the piezoelectric body. As a result, the possibility of occurring cracks in the piezoelectric body can be reduced.
   Note that, the surface roughness Rmax is 5-15 µm and the arithmetic average surface roughness Ra is 0.5-2 µm, according to an experiment where the flatness (roughness) of a wall surface of a through hole, corresponding to the above hollow cylindrical section, formed by using the simultaneous punching-laminating method in a body made by laminating 500 ceramics green sheets (thickness of each of the sheets is 100 µm) is examined. Further, the maximum height of an undulation curve Wt is 8-16 µm, and the arithmetic average undulation Wa is 0.5-1.5 µm. These values are even equal to the values obtained when the machining process is used and show that the flatness obtained by the simultaneous punching-laminating method is extremely good.
(2) Distance Dis (for maintaining electrical insulation) between the wall surface of the hollow cylindrical sections 303a1 and the internal electrode layer 302a shown in FIG. 35 can be made extremely short, since the flatness of the wall surface of the hollow cylindrical section 303a1 formed using the simultaneous punching-laminating method is extremely good, as mentioned above. This enables a portion within the piezoelectric body 301 where the electric field can not be applied (i.e., the inactive portion) to be very small. As a result, the piezoelectric body 301 has substantially no portion which neither expands nor contracts. Thus, an internal stress can be small compared to a piezoelectric body having both a portion which neither expands nor contracts and a portion which expands and contracts. Accordingly, the piezoelectric/electrostrictive actuator 300 manufactured by the simultaneous punching-laminating method has enhanced durability and a long service life. Note that, the distance Dis is preferably twice or more than the thickness t of one of layers laminated in view of maintaining steady electrical insulation.
(3) The electrical connection can be assured for a long time between the layer electrode section 303a2 formed on the inner wall of the hollow cylindrical section 303a and the internal electrode layers 302b, since the flatness of the wall surface of the hollow cylindrical section 303a1 formed using the simultaneous punching-laminating method is extremely good.
(4) Unlike the first embodiment, the piezoelectric/electrostrictive actuator 300 has no side-surface electrodes. Therefore, it is very easy to manufacture actuators having various outer shapes including a circular column, a square pole, and a hexagonal pole, shown in FIGS. 36A, 36B, and 36C, respectively. Note that, this advantage can be obtained from the piezoelectric/electrostrictive actuator 90 shown in FIG. 22 as well.
(5) Terminals for applying the predetermined voltage to the internal electrode layers can be made on the bottom surface of the piezoelectric/electrostrictive actuator 300. Thus, it is possible to adopt a configuration where the piezoelectric/electrostrictive actuator 300 is disposed on a circuit substrate. In other words, it is possible to omit lead wires for connecting the side-surface electrodes with a voltage source. Note that, this advantage can also be obtained from the piezoelectric/electrostrictive actuator 90 shown in FIG. 22 as well.

As described above, the piezoelectric/electrostrictive actuators according to the embodiments of the present invention have enhanced durability and increased expansion and contraction amounts.

Notably, the present invention is not limited to the above-described embodiments, and various modifications may be employed without departing from the scope of the invention. For example, the planar shape of the internal electrode layers are not limited to regular polygons, and may be an irregular polygon, a regular polygon having rounded corners, or an irregular polygon having rounded corners. Further, the piezoelectric body in the above-described embodiments may be an electrostrictive body which expands along the direction of an applied electric field.

## Claims

1. A piezoelectric/electrostrictive actuator comprising a piezoelectric body and a plurality of internal electrode layers formed in parallel within the piezoelectric body, in which a predetermined voltage is applied to the internal electrode layers so as to expand and contract the piezoelectric body,
wherein the internal electrode layers are disposed at a central portion of the piezoelectric body such that an active portion and an inactive portion are formed in the piezoelectric body, the active portion being the central portion of the piezoelectric body to which a voltage is applied so as to expand and contract the piezoelectric body, and the inactive portion being a peripheral portion of the piezoelectric body which surrounds the central portion of the piezoelectric body and in which no voltage is applied to the piezoelectric body and the piezoelectric body neither expands nor contracts, and
wherein the internal electrode layers are formed such that the width of the inactive portion, which is the distance between the outer edge of the piezoelectric body and the active portion, is at least a single layer thickness of the piezoelectric body, which is the distance between a pair of internal electrode layers facing each other, and, in a cross section in which each internal electrode layer is formed, the inactive portion has an area equal to or less than 50% the area of the entire cross section.

2. A piezoelectric/electrostrictive actuator comprising a piezoelectric body and a plurality of internal electrode layers formed in parallel within the piezoelectric body, in which a predetermined voltage is applied to the internal electrode layers so as to expand and contract the piezoelectric body,
wherein the internal electrode layers are disposed at a central portion of the piezoelectric body such that an active portion and an inactive portion are formed in the piezoelectric body, the active portion being the central portion of the piezoelectric body to which a voltage is applied so as to expand and contract the piezoelectric body, and the inactive portion being a peripheral portion of the piezoelectric body which surrounds the central portion of the piezoelectric body and in which no voltage is applied to the piezoelectric body and the piezoelectric body neither expands nor contracts, and
wherein the piezoelectric/electrostrictive actuator further comprises:
electrode lead portions each generally assuming the form of a strip and extending from the internal electrode layers to side surfaces of the piezoelectric body, the width of the strip being equal to or less than 30% the diameter of a circle which can be drawn in an internal electrode layer without extending outside the outer edge of the internal electrode layer, and the circle having the maximum area among all such circles; and
side-surface electrodes formed on the side surfaces of the piezoelectric body so as to connect together end portions of the corresponding electrode lead portions exposed to the side surfaces of the piezoelectric body.

3. A piezoelectric/electrostrictive actuator according to claim 2, wherein the shape of each internal electrode layer is a shape having n-fold symmetry, where n is an integer not less than 2, a rectangular shape, or an elliptical shape, or an oval shape.
